(19) Europäisches Patentamt
European Patent Office
Office européen des brevets

(11) EP 4 390 549 A1

(12) **EUROPEAN PATENT APPLICATION**
published in accordance with Art. 153(4) EPC

(43) Date of publication:
**26.06.2024 Bulletin 2024/26**

(21) Application number: **22858495.9**

(22) Date of filing: **17.08.2022**

(51) International Patent Classification (IPC):
***G03F 7/30** (2006.01)*

(52) Cooperative Patent Classification (CPC):
**G03F 7/30**

(86) International application number:
**PCT/JP2022/031092**

(87) International publication number:
**WO 2023/022177 (23.02.2023 Gazette 2023/08)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **18.08.2021 JP 2021133621**

(71) Applicant: **Asahi Kasei Kabushiki Kaisha**
**Tokyo 1000006 (JP)**

(72) Inventors:
- **HASEGAWA, Ryosuke**
  **Tokyo 100-0006 (JP)**
- **YOSHINO, Tomoya**
  **Tokyo 100-0006 (JP)**

(74) Representative: **D Young & Co LLP**
**3 Noble Street**
**London EC2V 7BQ (GB)**

(54) **PREDICTING DEVICE, DEVELOPING DEVICE, PREDICTING METHOD, AND PREDICTING PROGRAM**

(57) There is provided a predicting device including: a processing condition acquisition unit which acquires a development processing condition in developing; a developing solution data acquisition unit which acquires developing solution data indicating a composition of a developing solution; a prediction unit which generates prediction data in which a composition of a developing solution after development is predicted, based on the development processing condition and the developing solution data; and an output unit which outputs information corresponding to the prediction data. The prediction unit may use the prediction data as new developing solution data, repeatedly execute generation processing of the prediction data multiple times, and generate a prediction data group including pieces of the prediction data obtained multiple times.

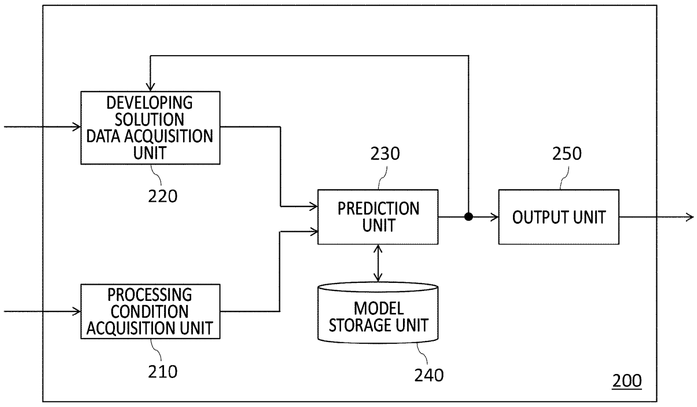


*FIG.2*

EP 4 390 549 A1

## Description

BACKGROUND

1. TECHNICAL FIELD

The present invention relates to a predicting device, a developing device, a predicting method, and a predicting program.

2. RELATED ART

Patent Document 1 discloses that "When a printing plate made of photosensitive resin is made, developing processing in which the printing plate exposed to a predetermined pattern is developed with a developer, is performed".

Prior Art Document

Patent Document

Patent Document 1: Japanese Patent Application Publication No. 2011-64796

General Disclosure

In a first aspect of the present invention, a predicting device is provided. The predicting device includes: a processing condition acquisition unit which acquires a development processing condition in developing; a developing solution data acquisition unit which acquires developing solution data indicating a composition of a developing solution; a prediction unit which generates prediction data in which a composition of a developing solution after development is predicted, based on the development processing condition and the developing solution data; and an output unit which outputs information corresponding to the prediction data.

In the predicting device, the prediction unit may use the prediction data as new developing solution data, repeatedly execute generation processing of the prediction data multiple times, and generate a prediction data group including pieces of the prediction data obtained multiple times.

In any of the predicting devices, the output unit may output at least a part of the prediction data group.

Any of the predicting devices may further include a recommended condition generation unit which generates a recommended condition for performing maintenance on the developing solution after the development, based on the prediction data group, and the output unit may output the recommended condition.

In any of the predicting devices, for each time the prediction data is generated, the recommended condition generation unit may generate the recommended condition that is individual for each cycle of development processing, based on the prediction data.

In any of the predicting devices, for each time the prediction data group is generated, the recommended condition generation unit may generate the recommended condition that is consistently common over development processing performed multiple times.

Any of the predicting devices may further include a control unit which controls a control target that performs the maintenance on the developing solution after the development, according to the recommended condition.

Any of the predicting devices may further include a diagnosis unit which diagnoses an abnormality in the developing based on the prediction data, and the output unit may output information corresponding to a result obtained by the diagnosis.

In any of the predicting devices, the diagnosis unit may diagnose that an abnormality has occurred in the developing solution after the development, when the prediction data is outside a predetermined management range.

In any of the predicting devices, the output unit may output a message to an effect that a full amount of the developing solution after the development should be replaced, when it is diagnosed that an abnormality has occurred in the developing solution after the development.

In any of the predicting devices, the diagnosis unit may diagnose that an abnormality has occurred in a developing device which executes the developing, when a difference between a development performance estimated from the prediction data and an actually measured development performance does not meet a predetermined standard.

In any of the predicting devices, the diagnosis unit may estimate a development performance from the prediction data, when the prediction data is within the management range.

In any of the predicting devices, the output unit may output a message to an effect that the developing being executed in the developing device should be stopped, when it is diagnosed that an abnormality has occurred in the developing device.

In any of the predicting devices, the prediction unit may generate the prediction data, by using a prediction model generated by performing machine learning on a relationship between (a) the development processing condition and the developing solution data and (b) used developing solution data indicating the composition of the developing solution after the development.

Any of the predicting devices may further include: a used developing solution data acquisition unit which acquires the used developing solution data; and a learning unit which generates the prediction model by performing machine learning on the development processing condition, the developing solution data, and the used developing solution data, as learning data.

In any of the predicting devices, the developing solution may be an alkaline aqueous developing solution containing at least any of a surfactant or a development accelerator, and the developing solution data acquisition unit may acquire, as the developing solution data, at least any of a concentration of a development residue, a concentration of the surfactant, a concentration of the development accelerator, or a pH in the developing solution, and the prediction unit may generate, as the prediction data, at least any of the concentration of the development residue, the concentration of the surfactant, the concentration of the development accelerator, or the pH in the developing solution after the development.

In any of the predicting devices, the processing condition acquisition unit may acquire, as the development processing condition, at least any of a type of a developing device, an amount of the developing solution, a temperature of the developing solution in the developing, a developing time, a contact pressure of a developing brush, a number of rotations of the developing brush, a maintenance condition of the developing solution, a size of a plate that is made, an image rate, or a development depth.

In any of the predicting devices, the developing solution may be a developing solution that is used for developing an original plate made of resin.

In a second aspect of the present invention, a developing device is provided. The developing device includes any of the predicting devices described above.

In a third aspect of the present invention, a predicting method is provided. The predicting method includes acquiring a development processing condition in developing; acquiring developing solution data indicating a composition of a developing solution; generating prediction data in which a composition of a developing solution after development is predicted, based on the development processing condition and the developing solution data; and outputting information corresponding to the prediction data.

In the predicting method, the generating the prediction data may include using the prediction data as new developing solution data, repeatedly executing generation processing of the prediction data multiple times, and generating a prediction data group including pieces of the prediction data obtained multiple times.

Any of the predicting methods may further include diagnosing that an abnormality has occurred in the developing solution after the development, when the prediction data is outside a predetermined management range.

Any of the predicting methods may further include diagnosing that an abnormality has occurred in a developing device which executes the developing, when a difference between a development performance estimated from the prediction data and an actually measured development performance does not meet a predetermined standard.

In a fourth aspect of the present invention, a predicting program is provided. The predicting program is executed by a computer and causes the computer to function as: a processing condition acquisition unit which acquires a development processing condition in developing; a developing solution data acquisition unit which acquires developing solution data indicating a composition of a developing solution; a prediction unit which generates prediction data in which a composition of a developing solution after development is predicted, based on the development processing condition and the developing solution data; and an output unit which outputs information corresponding to the prediction data.

The summary clause does not necessarily describe all necessary features of the embodiments of the present invention. The present invention may also be a sub-combination of the features described above.

BRIEF DESCRIPTION OF THE DRAWINGS

Fig. 1 shows a configuration example of a developing device 100 which develops an original plate.

Fig. 2 shows an example of a block diagram of a predicting device 200 according to the present embodiment.

Fig. 3 shows an example of a flow in which the predicting device 200 according to the present embodiment predicts a composition of a developing solution after development, and outputs information corresponding to a prediction result.

Fig. 4 shows a predicted trend of a development residue concentration that may be output by the predicting device 200 according to the present embodiment.

Fig. 5 shows a predicted trend of a surfactant concentration that may be output by the predicting device 200 according to the present embodiment.

Fig. 6 shows a predicted trend of a pH that may be output by the predicting device 200 according to the present embodiment.

Fig. 7 shows an example of a block diagram of the predicting device 200 according to a first modification example of the present embodiment.

Fig. 8 shows an example of a block diagram of the predicting device 200 according to a second modification example of the present embodiment.

Fig. 9 shows an example of a block diagram of the predicting device 200 according to a third modification example of the present embodiment.

Fig. 10 shows an example of a block diagram of the predicting device 200 according to a fourth modification example of the present embodiment.

Fig. 11 shows an example of a diagnostic flow that may be executed by the predicting device 200 according to the fourth modification example of the present embodiment.

Fig. 12 shows an example of accuracy of estimating a development performance by the predicting device 200 according to the fourth modification example of the present embodiment.

Fig. 13 shows an example of a first use case of the predicting device 200.

Fig. 14 shows an example of a second use case of the predicting device 200.

Fig. 15 shows an example of a computer 9900 in which a plurality of aspects of the present invention may be embodied in whole or in part.

DESCRIPTION OF EXEMPLARY EMBODIMENTS

Hereinafter, the present invention will be described through embodiments of the invention, but the following embodiments do not limit the invention according to the claims. In addition, not all of the combinations of features described in the embodiments are essential to the solving means of the invention.

Fig. 1 shows a configuration example of a developing device 100 which develops an original plate. Currently, as a printing method, planographic printing (offset printing), intaglio printing (gravure printing), letterpress printing (flexo printing), and the like are known. In order to perform such printing, it is necessary to make a printing plate in accordance with an image desired to be printed. For example, in a case of making a letterpress plate (a flexo printing plate), processing such as back exposure, laser drawing, relief exposure, development, drying, and post exposure is performed on an original plate containing an infrared sensitive layer or a photosensitive resin layer, thereby obtaining the printing plate. The developing device 100 shown in the present figure may be used, for example, for developing in such letterpress plate making. Further, a developing solution that is used for the developing device 100 may be a developing solution that is used for developing the original plate made of resin. This developing solution may be an aqueous developing solution containing at least a surfactant, or a solvent developing solution containing a saturated or unsaturated hydrocarbon, an ester, an alcohol, or the like. Among these, in the aqueous developing solution, a developing solution component changes significantly during the developing, and thus a benefit of performing a prediction of the developing solution component according to the present invention is great.

In such a developing device 100, a surface of the original plate is rubbed with a developing brush while the developing solution stored in a developing solution tank is supplied to the original plate, to remove an uncured (unexposed) photosensitive resin composition, whereby development processing is performed. At this time, the developing solution that is supplied to the original plate is recovered to the developing solution tank, and is stored in the developing solution tank again. Therefore, as the development processing progresses, the developing solution that is stored in the developing solution tank gradually contains the uncured photosensitive resin composition as a development residue. In addition, when an unexposed portion is removed from the surface of the original plate, the unexposed portion undergoes a chemical reaction with a part of the developing solution component, or the unexposed portion absorbs or adsorbs a part of the developing solution component, thereby decreasing a concentration of the developing solution component. For example, when the developing solution is an alkaline aqueous developing solution having the surfactant, a surfactant concentration or a pH decreases as the development processing progresses. An increase in a concentration of the development residue and a decrease in the concentration of the developing solution component cause a decrease in development performance (for example, a development speed).

Therefore, in the developing device 100, it is necessary to perform maintenance on the developing solution to suppress the increase in the concentration of the development residue and the decrease in the concentration of the developing solution component. As the maintenance, for example, in the developing device 100, for each time one sheet (or several sheets) is developed from the original plate, a certain amount of the developing solution in the developing solution tank is discharged, and the same amount of a new developing solution is added as a new solution at a predetermined concentration. In addition, for example, in the developing device 100, each time a predetermined number of sheets are developed from the original plate, the whole developing solution in the developing solution tank is discharged to be replaced with a new developing solution.

However, such periodic maintenance of the developing solution may be excessive depending on a condition of use of the developing device 100, and may result in an excessive running cost in the developing. Therefore, so-called condition-based maintenance is desired to grasp what composition of the developing solution is made after the original plate is developed to obtain the printing plate, and to perform the maintenance on the developing solution accordingly.

Fig. 2 shows an example of a block diagram of a predicting device 200 according to the present embodiment. In view of the above, the predicting device 200 according to the present embodiment acquires a development processing condition in the developing, and developing solution data indicating the composition of the developing solution; and predicts, based on these, the composition of the developing solution after the development. Then, the predicting device 200 outputs information corresponding to a prediction result. In this manner, with the predicting device 200 according to the present embodiment, it is possible to predict the composition of the developing solution after the original plate is developed, without performing a detailed component measurement, and to provide a user with the information corresponding to the prediction result.

The predicting device 200 according to the present embodiment may be a computer such as a PC (personal computer), a tablet computer, a smartphone, a workstation, a server computer, or a general-purpose computer, or may be a computer system to which a plurality of computers are connected. Such a computer system is also a computer in a broad sense. In addition, the predicting device 200 may be implemented by one or more virtual computer environments executable in a computer. Instead of this, the predicting device 200 may be a dedicated computer designed to predict the composition of the developing solution, or may be dedicated hardware realized by dedicated circuitry. In addition, when the predicting device 200 is able to be connected to the Internet, the predicting device 200 may be realized by cloud computing.

In addition, the predicting device 200 may be configured as the same device as the developing device 100. That is, the developing device 100 which develops the original plate may include the predicting device 200 according to the present embodiment. This makes it possible to provide, by an integrated device, a function of developing the original plate and a function of predicting the composition of the developing solution. When the developing device 100 and the predicting device 200 are provided as an integrated device, the predicting device 200 is able to directly acquire, from the developing device 100, the development processing condition in the developing. For example, it is possible to acquire, from log data in the developing device 100, an actual measured value such as a developing solution temperature during the development processing, and thus it is possible to accurately predict the developing solution data after the development processing. Instead of this, the predicting device 200 may be configured as a device different from the developing device 100. This makes it possible to provide, by separate devices, the function of developing the original plate and the function of predicting the composition of the developing solution.

The predicting device 200 includes a processing condition acquisition unit 210, a developing solution data acquisition unit 220, a prediction unit 230, a model storage unit 240, and an output unit 250. It is to be noted that these blocks are functional blocks that are functionally separated, respectively, and do not necessarily need to match with actual device configurations. In other words, in the present figure, a unit shown as one block does not necessarily need to be configured by one device. In addition, in the present figure, units shown as separate blocks do not necessarily need to be configured by separate devices.

The processing condition acquisition unit 210 acquires the development processing condition in the developing. For example, the processing condition acquisition unit 210 acquires the development processing condition in the developing, from the developing device 100, via a network. However, the present invention is not limited to this. The processing condition acquisition unit 210 may acquire the development processing condition via a user input, or may acquire the development processing condition by reading from various types of memory devices. The processing condition acquisition unit 210 supplies the acquired development processing condition to the prediction unit 230.

The developing solution data acquisition unit 220 acquires the developing solution data indicating the composition of the developing solution. For example, the developing solution data acquisition unit 220 acquires the developing solution data indicating the initial composition of the developing solution used for the developing, from the information such as a component list of the developing solution. However, the present invention is not limited to this. The developing solution data acquisition unit 220 may acquire the developing solution data indicating the composition of the initial developing solution used for the developing, via the user input, or may acquire the developing solution data by reading from various types of memory devices. Such an initial developing solution may be a developing stock solution, or may be a diluted stock solution obtained by diluting the developing stock solution. In addition, the developing solution data acquisition unit 220 acquires, as new developing solution data, prediction data that is generated by the prediction unit 230 which will be described below. The developing solution data acquisition unit 220 supplies the acquired developing solution data to the prediction unit 230.

The prediction unit 230 generates the prediction data in which the composition of the developing solution after the development is predicted, based on the development processing condition and the developing solution data. For example, the prediction unit 230 generates the prediction data in which the composition of the developing solution after the development is predicted, based on the development processing condition acquired by the processing condition acquisition unit 210, and the developing solution data acquired by the developing solution data acquisition unit 220. At this time, the prediction unit 230 may generate the prediction data, by using a prediction model generated by performing machine learning on a relationship between (a) the development processing condition and the developing solution data and (b) used developing solution data indicating the composition of the developing solution after the development.

The model storage unit 240 stores the prediction model generated by performing machine learning on the relationship between (a) the development processing condition and the developing solution data and (b) the used developing solution data. Such a prediction model may be generated by another device different from the predicting device 200. In this manner, the predicting device 200 can cause an external device to execute the processing of generating the prediction model, and thus it is possible to reduce a processing load. Instead of this, such a prediction model may be generated in the predicting device 200. This will be described below.

The prediction unit 230 reads the prediction model stored in the model storage unit 240 in this way. Then, the prediction unit 230 inputs the development processing condition and the developing solution data to the read prediction model, and acquires an output of the prediction model as the prediction data. In this way, the prediction unit 230 may use the prediction model generated by machine learning to generate the prediction data. However, the present invention is not limited to this. The prediction unit 230 may generate the prediction data by inputting the development processing condition and the developing solution data into a known function based on a theoretical formula or an empirical rule. In addition, in a case where the maintenance of the developing solution is performed, when the developing solution data is predicted, the prediction unit 230 may acquire the prediction model that predicts the developing solution data after the development processing and the maintenance are performed; or may acquire the prediction model that predicts the developing solution data after the development processing but before the maintenance is performed, and separately use an algorithm that predicts the developing solution data after the maintenance from the developing solution data acquired from the prediction model. The prediction unit 230 supplies the generated prediction data to the output unit 250. In addition, the prediction unit 230 supplies the generated prediction data to the developing solution data acquisition unit 220.

The output unit 250 outputs the information corresponding to the prediction data. For example, the output unit 250 outputs the information corresponding to the prediction data generated by the prediction unit 230, and displays the information on a monitor. However, the present invention is not limited to this. The output unit 250 may output the information corresponding to the prediction data by an audio output by a speaker, may output the information by a print output by a printer, may output the information by a signal transmission output to another functional unit or another device. At this time, as the information corresponding to the prediction data, the output unit 250 may output the prediction data (group) itself in which the composition of the developing solution after the development is predicted; or may output the information generated based on the prediction data (group), for example, at least any of the development performance in accordance with a trend in the prediction data, a recommended condition for performing the maintenance on the developing solution after the development, or a maintenance cost, or the like: or may output a combination of these. This will be described below.

Fig. 3 shows an example of a flow in which the predicting device 200 according to the present embodiment predicts a composition of a developing solution after development, and outputs information corresponding to a prediction result. In step S300, the predicting device 200 sets i to 1. Here, i indicates the number of sheets developed from the original plate. That is, at a time of i = 1, the predicting device 200 predicts the composition of the developing solution after one sheet is developed from the original plate.

In step S310, the predicting device 200 acquires the development processing condition. For example, the processing condition acquisition unit 210 acquires the development processing condition in the developing, from the developing device 100, via the network. At this time, the processing condition acquisition unit 210 may acquire, as the development processing condition, at least any of a type of a developing device, an amount of the developing solution, the temperature of the developing solution in the developing, a developing time, a contact pressure of the developing brush, the number of rotations of the developing brush, a maintenance condition of the developing solution, a size of the plate that is made, an image rate, or a development depth. However, the present invention is not limited to this. The processing condition acquisition unit 210 may acquire, as the development processing conditions, various conditions that may affect the composition of the developing solution after the development. The temperature of the developing solution, a developing time, or the like in the developing may be a set value; however, it is preferable to use the actual measured value that is acquired from the log data or the like because the prediction accuracy of the prediction unit 230 is enhanced. The processing condition acquisition unit 210 supplies the acquired development processing condition to the prediction unit 230.

In step S320, the predicting device 200 acquires the developing solution data. In step S320 following step S310, the developing solution data acquisition unit 220 acquires, for example, the developing solution data indicating the initial composition of the developing solution used for the developing, from the information such as a component list of the developing solution. When the developing solution is the alkaline aqueous developing solution containing at least the surfactant, the developing solution data acquisition unit 220 may acquire, as the developing solution data, at least any of the concentration of the development residue, the concentration of the surfactant, or the pH in the developing solution.

As an example, in the developing device 100, it is assumed to use, as the initial developing solution, a diluted stock solution obtained by diluting, by a factor of 25, a developing stock solution containing 50% surfactant and 25% pH adjuster. In this case, as the initial developing solution data, the developing solution data acquisition unit 220 may acquire the concentration of the development residue in the diluted stock solution = 0%, the concentration of the surfactant at 2%, and the pH of the diluted stock solution. However, the present invention is not limited to this. The developing solution data acquisition unit 220 may acquire, as the developing solution data, the concentrations and characteristics of various components that may affect the development performance. The developing solution data acquisition unit 220 supplies the acquired developing solution data to the prediction unit 230.

In step S330, the predicting device 200 generates the prediction data. For example, the prediction unit 230 generates the prediction data in which the composition of the developing solution after the development is predicted, based on the development processing condition acquired in step S310 and the developing solution data acquired in step S320. As an example, the prediction unit 230 reads the prediction model stored in the model storage unit 240. Then, the prediction unit 230 inputs, to the read prediction model, the development processing condition acquired in step S310 and the developing solution data acquired in step S320; and acquires the output of the prediction model, as the prediction data. In this way, the prediction unit 230 may generate the prediction data, by using the prediction model generated by performing machine learning on the relationship between (a) the development processing condition and the developing solution data and (b) the used developing solution data indicating the composition of the developing solution after the development. It is to be noted that the used developing solution data may include the same item as that of the developing solution data. That is, here, the used developing solution data may include the concentration of the development residue, the concentration of the surfactant, and the pH, in the developing solution after the development.

In step S340, the predicting device 200 determines whether i = J. Here, J is a predetermined number of repetitions, and here indicates a maximum number of sheets to be developed from the original plate. If it is determined that i = J is not true (in the case of No), the prediction unit 230 supplies the prediction data generated in step S330 to the developing solution data acquisition unit 220. Then, the predicting device 200 advances the processing to step S350.

In step S350, the predicting device 200 increments i. Then, the predicting device 200 returns the processing to step S320. Accordingly, in step S320 following step S350, the developing solution data acquisition unit 220 acquires the prediction data generated in immediately previous step S330 as new developing solution data. Then, in step S 330, the prediction unit 230 inputs, to the read prediction model, the development processing condition acquired in step S310 and the prediction data generated in step S330; and acquires the output of the prediction model, as the prediction data. That is, at a time of i = 2, the prediction unit 230 uses, as the new developing solution data, the prediction data in which the composition of the developing solution after one sheet is developed from the original plate, is predicted; and predicts the composition of the developing solution after two sheets are developed from the original plate. Similarly, at a time of i = 3, the prediction unit 230 uses, as the new developing solution data, the prediction data in which the composition of the developing solution after two sheets are developed from the original plate, is predicted; and predicts the composition of the developing solution after three sheets are developed from the original plate. In this way, until i = J, the prediction unit 230 uses the prediction data generated in step S330 as the new developing solution data, repeatedly executes generation processing of the prediction data multiple times, and generates the prediction data group including pieces of prediction data obtained multiple times.

On the other hand, if it is determined that i = J (in the case of Yes), the prediction unit 230 supplies, to the output unit 250, J pieces of prediction data generated so far. Then, the predicting device 200 advances the processing to step S360.

In step S360, the predicting device 200 outputs the information corresponding to the prediction data. For example, the output unit 250 outputs the information corresponding to the prediction data generated in step S330, and displays the information on the monitor. As an example, the output unit 250 may output at least a part of the prediction data group generated by the prediction unit 230. At this time, the output unit 250 may output a trend of pieces of prediction data obtained multiple times, or may output the development performance in accordance with the trend of the prediction data.

Fig. 4 shows a predicted trend of a development residue concentration that may be output by the predicting device 200 according to the present embodiment. In the present figure, the horizontal axis indicates the number of sheets i developed from the original plate. In addition, in the present figure, the vertical axis indicates the development residue concentration in the developing solution after the development, which is generated as the prediction data by the prediction unit 230. The present figure shows, as an example, a case where J which is the number of repetitions is 60. That is, the present figure shows the trend of the development residue concentration repeatedly predicted for 60 times by the prediction unit 230 from i = 1 to i = 60. It is to be noted that as the development residue concentration when i = 0, the development residue concentration in the initial developing solution may be used as is. The output unit 250 may output, for example, such a predicted trend of the development residue concentration as the information corresponding to the prediction data.

Fig. 5 shows a predicted trend of a surfactant concentration that may be output by the predicting device 200 according to the present embodiment. In the present figure, the horizontal axis indicates the number of sheets i developed from the original plate. In addition, in the present figure, the vertical axis indicates the concentration of the surfactant in the developing solution after the development, which is generated as the prediction data by the prediction unit 230. The present figure shows, as an example, a case where J which is the number of repetitions is 60. That is, the present figure shows the trend of the surfactant concentration repeatedly predicted for 60 times by the prediction unit 230 from i = 1 to i = 60. It is to be noted that as the surfactant concentration when i = 0, the concentration of the surfactant in the initial developing solution may be used as is. For example, the output unit 250 may output such a predicted trend of the surfactant concentration, as the information corresponding to the prediction data.

Fig. 6 shows a predicted trend of a pH that may be output by the predicting device 200 according to the present embodiment. In the present figure, the horizontal axis indicates the number of sheets i developed from the original plate. In addition, in the present figure, the vertical axis indicates the pH in the developing solution after the development, which is generated as the prediction data by the prediction unit 230. The present figure shows, as an example, a case where J which is the number of repetitions is 60. That is, the present figure shows the trend of the pH repeatedly predicted for 60 times by the prediction unit 230 from i = 1 to i = 60. It is to be noted that as the pH when i = 0, the pH in the initial developing solution may be used as is. The output unit 250 may output, for example, such a predicted trend of the pH as the information corresponding to the prediction data.

In this way, the output unit 250 may output the trend of pieces of prediction data that are obtained multiple times and are repeatedly predicted. This makes it possible for the output unit 250 to output the information indicating how the composition of the developing solution changes as a plurality of sheets are developed from the original plates. However, the present invention is not limited to this. As long as it is possible to predict how the composition of the developing solution will change, the predicting device 200 can also predict, based on that, the development performance of the developing solution. Accordingly, the output unit 250 may output the development performance in accordance with the trend of the prediction data.

In addition, in the above description, the case where the output unit 250 outputs the whole prediction data group generated by the repeated prediction from i = 1 to i = 60, is shown as an example; however, the output unit 250 may output a part of the prediction data group. That is, for example, the prediction unit 230 may repeatedly predict from i = 1 to i = 60, and the output unit 250 may output from i = 1 to i = 20. In this manner, the predicting device 200 may output only a characteristic part where the composition change is great. In this way, the output unit 250 may output at least a part of the prediction data group generated by the repeated prediction.

It is to be noted that in outputting Fig. 4 to Fig. 6, the predicting device 200 generates the prediction data under a condition that for each time one sheet is developed from the original plate in the developing device 100, a certain amount of the developing solution in the developing solution tank is discharged, and the same amount of new developing solution is added as the new solution at a concentration higher than that of the initial developing solution. However, in spite of this, the prediction result that the development residue concentration gradually increases, may be obtained. This means that as the plurality of sheets are developed from the original plate, the developing solution becomes fatigued (degraded) and the development performance deteriorates.

In this way, the predicting device 200 according to the present embodiment acquires the development processing condition in the developing, and the developing solution data indicating the composition of the developing solution; and predicts, based on these, the composition of the developing solution after the development. Then, the predicting device 200 outputs the information corresponding to the prediction result. In this manner, with the predicting device 200 according to the present embodiment, it is possible to predict the composition of the developing solution after the original plate is developed, without performing a detailed component measurement, and to provide the user with the information corresponding to the prediction result. In this manner, the user can grasp what composition of the developing solution is made after the original plate is developed, and for example, can optimize the condition for performing the maintenance on the developing solution accordingly. Here, for example, when the development processing is performed on 60 sheets of the original plate from i = 1 to i = 60, it is possible to optimize the maintenance condition on a premise that the same maintenance is consistently performed after the development processing from a first sheet to a 60th sheet (hereinafter referred to as a "proposal of a uniform condition"). In this case, for example, the optimal maintenance condition is calculated based on the prediction data group (the trend) from i = 1 to i = 60. Instead of this, it is also possible to propose the optimal maintenance condition for each time the development processing is performed on one sheet of the original plate (hereinafter referred to as a "proposal of a predictive control condition"). For example, a concept of a model predictive control can be used for this. In a state after the development processing is performed on the first (i = 1) sheet of the original plate, it is possible to optimize a maintenance method for i = 2 such that: the prediction data, in which the developing solution component after the development processing is performed on the second (i = 2) sheet of the original plate is predicted, is caused to be generated; and the concentration of the developing solution component indicated by the prediction data is able to be controlled within a predetermined range. As the recommended condition for the optimized maintenance as described above, for example, when the proposal is the uniform condition, formats thereof include "adding 12L of a new solution with a concentration of 4% (discarding 12L) for each time three sheets are developed", and "adding 5 L of a new solution with a concentration of 5% for each time one sheet is developed (discarding 5 L), and after repeating this for 300 sheets, replacing the whole developing solution". In addition, in the proposal of the predictive control condition, by configuring the predicting device 200 and the developing device 100 as the same device, or by causing a communication to be performed, it is possible to transmit, to the developing device 100, the maintenance condition optimized by the predicting device 200, and to cause the maintenance to be automatically executed, and thus it is possible to reduce an operational load on the user. In addition, with the predicting device 200 according to the present embodiment, when a development abnormality occurs, the user can distinguish between the abnormality due to the developing solution and the abnormality due to something else, and the like, and thus it is also possible to contribute to solving a cause at a time of a quality abnormality.

In addition, the predicting device 200 according to the present embodiment uses the prediction data as the new developing solution data, repeatedly executes the generation processing of the prediction data multiple times, and generates the prediction data group including pieces of prediction data obtained multiple times. In this manner, with the predicting device 200 according to the present embodiment, it is possible to repeatedly predict the composition of the developing solution when the used developing solution is reused to develop a next original plate.

Fig. 7 shows an example of a block diagram of the predicting device 200 according to a first modification example of the present embodiment. In Fig. 7, members having the same functions and configurations as those in Fig. 2 are denoted by the same signs and numerals, and the descriptions thereof will be omitted except for the following differences. In addition to the function of the predicting device 200 described above, the predicting device 200 according to the present modification example further has a function of generating the prediction model by machine learning. The predicting device 200 according to the present modification example further includes a used developing solution data acquisition unit 710 and a learning unit 720.

The used developing solution data acquisition unit 710 acquires the used developing solution data. For example, the used developing solution data acquisition unit 710 acquires, from the developing device 100 via the network, the used developing solution data obtained by measuring the component of the used developing solution that is discharged from the developing solution tank in which the developing solution after the development is stored. However, the present invention is not limited to this. The used developing solution data acquisition unit 710 may acquire such used developing solution data via the user input, or may acquire the used developing solution data by reading from various types of memory devices. The used developing solution data acquisition unit 710 supplies the acquired used developing solution data to the learning unit 720. In addition, in the present modification example, the processing condition acquisition unit 210 supplies the acquired processing condition to the learning unit 720 in addition to the prediction unit 230. Similarly, the developing solution data acquisition unit 220 supplies the acquired developing solution data to the learning unit 720 in addition to the prediction unit 230.

The learning unit 720 generates the prediction model by performing machine learning on the development processing condition, the developing solution data, and the used developing solution data, as learning data. For example, the learning unit 720 performs machine learning on the processing condition acquired by the processing condition acquisition unit 210, the developing solution data acquired by the developing solution data acquisition unit 220, and the used developing solution data acquired by the used developing solution data acquisition unit 710, as the learning data. Then, the learning unit 720 generates the prediction model that outputs the composition of the developing solution after the development, according to the inputs of the processing condition and the developing solution data. It is to be noted that as such a machine learning algorithm, any algorithm that is able to generate the prediction model capable of predicting the composition of the developing solution after the development, such as a neural network, a regression, a support vector machine, a random forest, a decision tree, clustering, and a principal component analysis, may be used. The learning unit 720 supplies the generated prediction model to the model storage unit 240. In this manner, the model storage unit 240 may store the prediction model generated by the learning unit 720.

In this way, the predicting device 200 according to the present modification example acquires the used developing solution data and generates the prediction model by performing machine learning on the processing condition, the developing solution data, and the used developing solution data, as the learning data. In this manner, with the predicting device 200 according to the present modification example, the function of predicting the developing solution and the function of generating the prediction model can be provided by an integrated device.

Fig. 8 shows an example of a block diagram of the predicting device 200 according to a second modification example of the present embodiment. In Fig. 8, members having the same functions and configurations as those in Fig. 2 are denoted by the same signs and numerals, and the descriptions thereof will be omitted except for the following differences. In the above description, the case where the predicting device 200 outputs the prediction data (group) itself as the information corresponding to the prediction data, is shown as an example. However, the present invention is not limited to this. In addition to the function of the predicting device 200 described above, the predicting device 200 according to the present modification example further has a function of generating the maintenance condition of the developing solution in consideration of the prediction result. The predicting device 200 according to the present modification example further includes a recommended condition generation unit 810. In the predicting device 200 according to the present modification example, the prediction unit 230 supplies the generated prediction data to the recommended condition generation unit 810 in addition to the output unit 250.

The recommended condition generation unit 810 generates the recommended condition for performing the maintenance on the developing solution after the development, based on the prediction data group. For example, the recommended condition generation unit 810 generates the recommended condition for performing the maintenance on the developing solution after the development, based on the prediction data group generated by the prediction unit 230.

As an example, the recommended condition generation unit 810 takes into consideration the prediction data group generated by the prediction unit 230, or the development performance of the developing solution based on the prediction data group; and generates, as the recommended condition, a recommended timing for performing the maintenance on the developing solution after the development, such as the number of sheets that are developed for each time before the new solution partially should replace a part of the developing solution stored in the developing solution tank, the number of sheets that are developed for each time before the new solution should replace the whole developing solution stored in the developing solution tank, or the like. In this way, the recommended condition generation unit 810 may generate the timing for performing the maintenance on the developing solution after the development, as the recommended condition.

In addition, in a case of partially replacing a part of the developing solution, the recommended condition generation unit 810 generates, as the recommended condition, the condition regarding how many liters of developing solution should be discharged after the development, how many liters of new solution should be added, how many times the developing stock solution should be diluted to be used as the new solution, or the like. In this way, the recommended condition generation unit 810 may generate, as the recommended condition, at least any of the timing for discharging a part or whole of the developing solution, the amount of the new solution to be added (discharged) at that time, or the concentration of the new solution. At this time, the recommended condition generation unit 810 may adopt the "proposal of the predictive control condition" or the "proposal of the uniform condition" described above. When the "proposal of the predictive control condition" is adopted, the recommended condition generation unit 810 may generate the optimal maintenance condition as the recommended condition for each time the development processing is performed on one sheet of the original plate. In this way, for each time the prediction data is generated, the recommended condition generation unit 810 may generate the recommended condition that is individual for each cycle of development processing, based on the prediction data. In this case, the maintenance condition that is individual is generated for each time (for example, for each sheet), and thus it is possible to enhance the accuracy and effectiveness of the maintenance. Such a "proposal of the predictive control condition" is particularly useful when the predicting device 200 further provides a function of controlling a control target that performs the maintenance on the developing solution, as will be described below. Instead of this, when the "proposal of the uniform condition" is adopted, the recommended condition generation unit 810 may generate the optimal maintenance condition, as the recommended condition, based on the prediction data group (the trend) from $i = 1$ to $i = 60$. In this way, for each time the prediction data group is generated, the recommended condition generation unit 810 may generate the recommended condition that is consistently common over the development processing performed multiple times, based on the prediction data group. In this case, the maintenance condition that is consistently common is generated, and thus it is possible to reduce a burden of maintenance management. The recommended condition generation unit 810 supplies the generated recommended condition to the output unit 250. In this manner, the output unit 250 may output the recommended condition.

At this time, the recommended condition generation unit 810 may further generate the maintenance cost when the maintenance is performed on the developing solution after the development according to the generated recommended condition. Then, the output unit 250 may further output the maintenance cost.

In this way, the predicting device 200 according to the present modification example generates and outputs the recommended condition for the maintenance based on the prediction data group. In this manner, with the predicting device 200 according to the present modification example, as the information corresponding to the prediction data, instead of or in addition to the prediction data (group) itself, it is possible to provide, to the user, the recommended condition for the maintenance, the maintenance cost, or the like, based on the prediction data.

Fig. 9 shows an example of a block diagram of the predicting device 200 according to a third modification example of the present embodiment. In Fig. 9, members having the same functions and configurations as those in Fig. 8 are denoted by the same signs and numerals, and the descriptions thereof will be omitted except for the following differences. In the above description, the case where the predicting device 200 outputs the generated recommended condition to an outside is shown as an example. However, the present invention is not limited to this. In addition to the function provided by the predicting device 200 described above, the predicting device 200 according to the present modification example further provides a function of controlling the control target that performs the maintenance on the developing solution. The predicting device 200 according to the present modification example further includes a control unit 910. In the predicting device 200 according to the present modification example, the output unit 250 supplies the generated recommended condition to the control unit 910 instead of or in addition to outputting the recommended condition to the outside.

The control unit 910 controls the control target that performs the maintenance on the developing solution after the development, according to the recommended condition. Here, as described above, the recommended condition generation unit 810 can generate, as the recommended condition, the timing to replace the developing solution (partially or by a full amount), the amount of discharge of the developing solution (the used developing solution) after the development, the amount of addition of the new solution, and the concentration of the new solution that is added. Accordingly, the control unit 910 may perform, according to the recommended condition, an opening and closing, ON/OFF control, at a predetermined timing, on a valve or a pump for discharging the developing solution after the development from the developing solution tank, the valve or the pump for adding the new solution to the developing solution tank, the valve or the pump for diluting the new solution, and the like.

In this way, the predicting device 200 according to the present modification example further includes a control unit which controls the control target that performs the maintenance on the developing solution, according to the recommended condition. In this manner, with the predicting device 200 according to the present modification example, the prediction function of predicting the composition of the developing solution and the controller function of controlling the composition of the developing solution can be provided by an integrated device. Accordingly, with the predicting device 200 according to the present modification example, in performing the maintenance on the developing solution, the result obtained by predicting the composition of the developing solution can be applied to an actual control without a human intervention.

Fig. 10 shows an example of a block diagram of the predicting device 200 according to a fourth modification example of the present embodiment. In Fig. 10, members having the same functions and configurations as those in Fig. 2 are denoted by the same signs and numerals, and the descriptions thereof will be omitted except for the following differences. In addition to the function provided by the predicting device 200 described above, the predicting device 200 according to the present modification example further provides a function of diagnosing an abnormality in the developing. The predicting device 200 according to the present modification example further includes a diagnosis unit 1010. In the predicting device 200 according to the present modification example, the prediction unit 230 supplies the generated prediction data to the diagnosis unit 1010 instead of or in addition to the output unit 250.

The diagnosis unit 1010 diagnoses the abnormality in the developing based on the prediction data. The diagnosis unit 1010 supplies a result obtained by the diagnosis to the output unit 250. Then, the output unit 250 outputs the information corresponding to the result obtained by the diagnosis by the diagnosis unit 1010. The details of this are described below.

Fig. 11 shows an example of a diagnostic flow that may be executed by the predicting device 200 according to the fourth modification example of the present embodiment. The present flow describes, as an example, a case where the developing solution is the aqueous developing solution containing: the surfactant (here, Newcol (registered trademark) NT-7 and Newcol NT-9); a development accelerator (here, diethylene glycol monohexyl ether (HeDG) and diethylene glycol dibutyl ether (DBDG)); a pH adjuster (here, potassium carbonate); and water. In this way, the developing solution may be the aqueous developing solution containing at least any of the surfactant or the development accelerator, and may be preferably the aqueous developing solution containing both of the surfactant and the development accelerator. However, the present invention is not limited to this. The developing solution may be the aqueous developing solution containing another component (including a neutral aqueous developing solution), or may be another developing solution such as the solvent developing solution as described above.

Here, in the developing in the making of the letterpress plate, when the developing solution described above is supplied to the original plate of the photosensitive resin (the unexposed portion), the resin swells with the developing solution and is in a brittle state. In such a state, by scraping the surface of the original plate with the brush, the uncured photosensitive resin is scraped out from the original plate, and is discharged together with the developing solution.

The surfactant that is contained in the developing solution has a function of dispersing the scraped out unexposed resin in the developing solution, and thus it is thought that when the concentration of the surfactant decreases, the unexposed resin is easily re-agglomerate in the developing solution. In addition, the development accelerator that is contained in the developing solution has a function of softening the resin, it is thought that when the concentration of the development accelerator decreases, scraping out with the brush becomes difficult. In addition, when the concentration of the development residue (the resin) of the developing solution increases, it becomes difficult for the unexposed resin of the original plate to absorb the developing solution, and thus it is thought that a rate of swelling slows down. In addition, when the pH decreases as well, the swelling rate of the unexposed resin of the original plate may slow down.

Accordingly, in order to maintain the desired development performance, particularly the desired development speed (the depth of the unexposed resin that is scraped out per unit time), it is important to control the concentration of the development residue, the concentration of the surfactant, the concentration of the development accelerator, and the pH in the developing solution.

However, in measuring the concentration of each component of the developing solution, for example, an analysis of gas chromatography, liquid chromatography, or the like is required, and the measurement requires a time and an effort by an operator with specialized knowledge. In addition, in many cases, in a plate making company and a printing company that have the developing devices installed, devices capable of performing such an analysis are not installed, and it is required to sample the developing solution first and then take the sampled developing solution to a laboratory where it is possible to perform the analysis. In this way, a current situation is that it is not possible to realize real-time on-site sensing of the composition of the developing solution. Accordingly, when an abnormality occurs in the developing (for example, the desired development depth cannot be obtained), it is not possible to distinguish between the abnormality due to the developing solution and the abnormality due to the developing device, and it takes time for analyzing the cause and for recovery. Therefore, by executing the present flow, the predicting device 200 according to the present modification example can distinguish between the abnormality due to the developing solution and the abnormality due to the developing device.

In step S1110, the developments of a predetermined number of sheets are performed in the developing device. Here, the predetermined number of sheets may be a number of one or more set in advance. Here, a case where the predetermined number of sheet is one will be described as an example; however, the predetermined number of sheets may be a plural number.

In step S1120, the predicting device 200 predicts the composition of the developing solution after the development. The predicting device 200 may generate, by executing the flow of Fig. 3, the prediction data in which the composition of the developing solution after the development is predicted. At this time, the processing condition acquisition unit 210 may acquire, as the development processing condition, the type (a model) of the developing device, the size (a length, a width, and a thickness) of the plate that is made, the image rate, and the development depth. In addition, the developing solution data acquisition unit 220 may acquire, as the developing solution data, the concentration of the development residue, the concentration of the surfactant (total concentration of NT-7 and NT-9), the concentration of DBDG, the concentration of HeDG, and the pH, in the developing solution. Then, the prediction unit 230 may generate the prediction data in which the composition of the developing solution after the development is predicted, with: each item of the development processing condition and the developing solution data being set as an explanatory variable X; and the concentration of the development residue, the concentration of the surfactant, the concentration of DBDG, the concentration of HeDG, and the pH, in the developing solution after the development, being set as an objective variable Y. In this way, the developing solution data acquisition unit 220 may acquire, as the developing solution data, at least any of the concentration of the development residue, the concentration of the surfactant, the concentration of the development accelerator, or the pH in the developing solution, and preferably all of them. In addition, the prediction unit 230 may generate, as the prediction data, at least any of the concentration of the development residue, the concentration of the surfactant, the concentration of the development accelerator, or the pH in the developing solution after the development, and preferably all of them. The prediction unit 230 supplies the generated prediction data to the diagnosis unit 1010.

In step S1130, the predicting device 200 determines whether the prediction data is within a management range. Here, the management range is assumed to be set, in advance, to ranges where the concentration of the development residue $< 3\%$, $2\% <$ the concentration of the surfactant $< 5\%$, $0.1\% <$ the concentration of DBDG $< 0.25\%$, $0.2\% <$ the concentration of HeDG $< 0.5\%$, and $9 < pH < 12$.

In this case, the diagnosis unit 1010 may determine whether each item of the prediction data generated in step S1120 is within the management range. That is, the diagnosis unit 1010 may determine whether the concentration of the development residue in the prediction data is smaller than 3%. Similarly, the diagnosis unit 1010 may determine whether the concentration of surfactant in the prediction data is greater than 2% and smaller than 5%. Similarly, the diagnosis unit 1010 may determine whether the concentration of DBDG in the prediction data is greater than 0.1% and smaller than 0.25%. Similarly, the diagnosis unit 1010 may determine whether the concentration of HeDG is greater than 0.2% and smaller than 0.5%. Similarly, the diagnosis unit 1010 may determine whether the pH in the prediction data is greater than 9 and smaller than 12.

In step S1130, if it is determined that at least any item in the prediction data is not within the management range (in the case of No), the predicting device 200 advances the processing to step S1132.

In step S1132, the predicting device 200 diagnoses the abnormality in the developing solution. For example, the diagnosis unit 1010 may diagnose that the abnormality has occurred in the developing solution after the development. For example, in this way, the diagnosis unit 1010 can diagnose that the abnormality has occurred in the developing solution after the development, when the prediction data is outside a predetermined management range. The diagnosis unit 1010 supplies, to the output unit 250, a diagnosis result indicating the abnormality in the developing solution.

In step S1134, the predicting device 200 outputs a message to an effect that a full amount should be replaced. For example, the output unit 250 may output the message to the effect that the full amount of the developing solution after the development should be replaced. For example, in this way, the output unit 250 can output the message to the effect that the full amount of the developing solution after the development should be replaced, when it is diagnosed that an abnormality has occurred in the developing solution after the development. At this time, the output unit 250 may output and display the message, may output the message by an audio output, may output the message by a print out, or may output the message by a transmission output. Accordingly, in the developing device, the whole developing solution in the developing solution tank may be discharged to be replaced with a new developing solution.

On the other hand, in step S1130, if it is determined that all items in the prediction data are within the management range (in the case of Yes), the predicting device 200 advances the processing to step S1140.

In step S1140, the predicting device 200 acquires the actual measured value of the development performance. For example, the diagnosis unit 1010 may acquire, as the actual measured value y_obseved of the development speed, the development depth per unit time calculated based on the actually measured value of the development depth of the original plate developed in step S1110.

In step S1150, the predicting device 200 estimates the development performance. For example, the diagnosis unit 1010 may estimate the development performance from the prediction data generated in step S1120.

As an example, the diagnosis unit 1010 may estimate the development performance using a linear model. Here, a case in which the development speed is estimated as the development performance will be described as an example. When an estimated value of the development speed is set as y, the concentration of the development residue in the prediction data is set as x1, the concentration of the surfactant is set as x2, the concentration of DBDG is set as x3, the concentration of HeDG is set as x4, the pH is set as x5, and a1 to a5 are set as coefficients of x1 to x5, the diagnosis unit 1010 may estimate the development speed by (Math 1).

(Math. 1)

$$y= a_1x_1 + a_2x_2 + a_3x_3 + a_4x_4 + a_5x_5 \cdot\cdot\cdot\cdot$$

That is, the diagnosis unit 1010 may estimate the development speed on the assumption that each factor linearly influences the development speed and that there is no correlation between the factors. It is to be noted that (Math. 1) shows, as an example, a case where x1 to x5 are the factors; however, the present invention is not limited to this. For example, at least any of x1 to x5 may be removed from the factors, or a factor other than x1 to x5 may be added.

In addition, the diagnosis unit 1010 can also enhance the accuracy of the model by machine learning. When λ is set as a parameter of a penalty term, the diagnosis unit 1010 can enhance the accuracy of the model by (Math. 2).

(Math. 2)

$$\arg\min\{\textstyle\sum_n (y_{observed} - y)^2 + \sum_i \lambda |a_i|\}$$

Here, a first item in a minimum point set (arg min: argument of the minimum) indicates a sum of squares of a difference between the actual measured value and the estimated value of the development speed. In addition, a second item of the minimum point set indicates the penalty term. For example, by using Lasso regression in this way, the diagnosis unit 1010 can put a weight and make a selection among a plurality of factors, and thereby can enhance the accuracy of the model. It is to be noted that in the above description, the case where the diagnosis unit 1010 uses the Lasso regression is shown as an example; however, the present invention is not limited to this. The diagnosis unit 1010 may use another regression algorithm different from the Lasso regression, or may use another machine learning algorithm different from the regression algorithm.

In step S1160, the predicting device 200 determines whether the estimated development performance meets a standard. For example, the diagnosis unit 1010 may compare the actual measured value y_obseved of the development speed acquired in step S1140, with the estimated value y of the development speed estimated in step S1150. Then, the diagnosis unit 1010 may determine that the estimated development performance does not meet the standard when an absolute value |y_obseved - y| of a difference between the actual measured value y_obseved of the development speed and the estimated value y of the development speed, exceeds a predetermined threshold value.

If it is determined in step S1160 that the estimated development performance does not meet the standard (in the case of No), the predicting device 200 advances the processing to step S1162.

In step S1162, the predicting device 200 diagnoses an abnormality in the developing device. For example, the diagnosis unit 1010 may diagnose that the abnormality has occurred in the developing device which executes the developing. For example, in this way, the diagnosis unit 1010 can diagnose that the abnormality has occurred in the developing device which executes the developing, when the difference between the development performance estimated from the prediction data and the actually measured development performance does not meet a predetermined standard. The diagnosis unit 1010 supplies, to the output unit 250, the diagnosis result indicating the abnormality in the developing device.

In step S1164, the predicting device 200 outputs a message to an effect that the developing should be stopped. For example, the output unit 250 may output the message to the effect that the developing being executed in the developing device should be stopped. For example, in this way, the output unit 250 can output the message to the effect that the developing being executed in the developing device should be stopped, when it is diagnosed that an abnormality has occurred in the developing device. At this time, the output unit 250 may output and display the message, may output the message by an audio output, may output the message by a print out, or may output the message by a transmission output. Accordingly, the developing may be stopped in the developing device. Then, In the developing device, the maintenance may be performed on the brush, a heater, or the like relating to the developing.

On the other hand, if it is determined in step S1160 that the estimated development performance meets the standard (in the case of Yes), the predicting device 200 advances the processing to step S1170.

In step S1170, the predicting device 200 determines whether the developments of all of the sheets have ended. If it is determined that the developments of all of the sheets have not ended (in the case of No), the predicting device 200 returns the processing to step S1110 and continues the flow. That is, the processing from step S1110 to step S1170 is repeated for each predetermined number of sheets.

On the other hand, if it is determined in step S1170 that the developments of all of the sheets have ended (in the case of Yes), the predicting device 200 ends the present flow.

Fig. 12 shows an example of accuracy of estimating a development performance by the predicting device 200 according to the fourth modification example of the present embodiment. In the present figure, the horizontal axis indicates the actual measured value y_obseved of the development speed. In addition, in the present figure, the vertical axis indicates the estimated value y of the development speed. In addition, in the present figure, the solid line indicates a diagonal matrix of the actual measured value y_obseved of the development speed and the estimated value y of the development speed. Accordingly, a case where the estimated value y of the development speed is equal to the actual measured value y_obseved of the development speed, makes plotting on a straight line. In the present figure, from the fact that the plotting is concentrated near the straight line, as well, it can be seen that the predicting device 200 can accurately estimate the development speed for the actual measured value.

In the related art, it is not possible to realize real-time on-site sensing of the composition of the developing solution. Therefore, when an abnormality occurs in the developing, it is not possible to distinguish between the abnormality due to the developing solution and the abnormality due to the developing device, and it takes time for analyzing the cause and for the recovery. On the other hand, with the predicting device 200, it is possible to generate the prediction data in which the composition of the developing solution after the development is predicted, and thus the real-time on-site sensing of the composition of the developing solution is possible without requiring a dedicated analyzing device or an operator with specialized knowledge. In this manner, with the predicting device 200, it is possible to use the prediction data and optimize the maintenance of the developing solution. In addition, with the predicting device 200, it is possible to use the prediction data and diagnose that the abnormality has occurred in the developing solution or the abnormality has occurred in the developing device, and thus even when the abnormality occurs in the developing, it is possible to distinguish between the abnormality due to the developing solution and the abnormality due to the developing device, and it is possible to significantly reduce the time required for the recovery. In addition, with the predicting device 200, it is possible to use the prediction data and accurately estimate the development performance, and thus it is possible to accurately detect the abnormality in the developing device which seemingly cannot be detected even by an experienced operator.

Fig. 13 shows an example of a first use case of the predicting device 200. As shown in the present figure, the predicting device 200 may be provided at a manufacturing site where the developing is executed in the developing device. At this time, the predicting device 200 and the developing device may be configured as an integrated device, or may be configured as separate devices. In this case, the predicting device 200 may acquire the explanatory variable X (each item of the development processing condition and the developing solution data) from the developing device or another device at the manufacturing site. Then, the predicting device 200 may store, in the cloud, the prediction data generated by using the acquired explanatory variable X, and various types of information that is generated by using the prediction data. In this manner, based on the prediction data and the various types of information stored in the cloud, the developing solution and the developing device may be maintained and managed in a technical support center.

Fig. 14 shows an example of a second use case of the predicting device 200. As shown in the present figure, the predicting device 200 may be provided at a location other than the manufacturing site, for example, such as the technical support center. In this case, the developing device or the other device at the manufacturing site may store the explanatory variable X in the cloud. Then, the predicting device 200 may generate the prediction data and the various types of information based on the explanatory variable X stored in the cloud, to maintain and manage the developing solution and the developing device based on these.

So far, various embodiments that are possible have been described as examples. However, the embodiment described above may be modified or applied in various modes. In particular, in the above description, the first to fourth modification examples are shown as independent modes, respectively; however, the present invention is not limited to this. Some or all of the first to fourth modification examples may be implemented in combination. That is, the predicting device 200 may have two or more combinations (including combinations of all) of the used developing solution data acquisition unit 710 and the learning unit 720, the recommended condition generation unit 810, the control unit 910, and the diagnosis unit 1010. At this time, for example, when the predicting device 200 includes the control unit 910 and the diagnosis unit 1010, the control unit 910 can also automatically replace a part or whole of the developing solution after the development (the developing solution in the developing solution tank), according to the diagnosis result by the diagnosis unit 1010.

Various embodiments of the present invention may be described with reference to flowcharts and block diagrams whose blocks may represent (1) steps of processes in which operations are performed or (2) sections of apparatuses responsible for performing operations. Certain steps and sections may be implemented by dedicated circuitry, programmable circuitry supplied with computer-readable instructions stored on computer-readable media, and/or processors supplied with computer-readable instructions stored on computer-readable media. Dedicated circuitry may include digital and/or analog hardware circuits, and may include integrated circuits (IC) and/or discrete circuits. The programmable circuitry may include a reconfigurable hardware circuit including logical AND, logical OR, logical XOR, logical NAND, logical NOR, and other logical operations, a memory element such as a flip-flop, a register, a field programmable gate array (FPGA) and a programmable logic array (PLA), and the like.

A computer-readable medium may include any tangible device that can store instructions to be executed by a suitable device, and as a result, the computer-readable medium having instructions stored thereon includes an article of manufacture including instructions which can be executed in order to create means for performing operations specified in the flowcharts or block diagrams. Examples of the computer-readable medium may include an electronic storage medium, a magnetic storage medium, an optical storage medium, an electromagnetic storage medium, a semiconductor storage medium, and the like. More specific examples of the computer-readable medium may include a floppy (registered trademark) disk, a diskette, a hard disk, a random access memory (RAM), a read-only memory (ROM), an erasable programmable read-only memory (EPROM or flash memory), an electrically erasable programmable read-only memory (EEPROM), a static random access memory (SRAM), a compact disc read-only memory (CD-ROM), a digital versatile disc (DVD), a Blu-ray (registered trademark) disc, a memory stick, an integrated circuit card, and the like.

The computer-readable instruction may include: an assembler instruction, an instruction-set-architecture (ISA) instruction; a machine instruction; a machine dependent instruction; a microcode; a firmware instruction; state-setting data; or either a source code or an object code written in any combination of one or more programming languages, including an object oriented programming language such as Smalltalk (registered trademark), JAVA (registered trademark), C++, or the like, and a conventional procedural programming language such as a "C" programming language or a similar programming language.

Computer-readable instructions may be provided to a processor of a general-purpose computer, special purpose computer, or other programmable data processing apparatuses, or to programmable circuitry, locally or via a local area network (LAN), wide area network (WAN) such as the Internet, or the like, so that the computer-readable instructions are executed to create means for performing operations specified in the flowcharts or block diagrams. Examples of the processor include a computer processor, a processing unit, a microprocessor, a digital signal processor, a controller, a microcontroller, and the like.

Fig. 15 shows an example of a computer 9900 in which a plurality of aspects of the present invention may be embodied in whole or in part. A program that is installed in the computer 9900 can cause the computer 9900 to function as operations associated with apparatuses according to the embodiments of the present invention or one or more sections of the apparatuses, or can cause the computer 9900 to execute the operations or the one or more sections thereof, and/or can cause the computer 9900 to execute processes according to the embodiments of the present invention or steps of the processes. Such a program may be executed by a CPU 9912 so as to cause the computer 9900 to execute certain operations associated with some or all of the flowcharts and the blocks in the block diagrams described herein.

The computer 9900 according to the present embodiment includes the CPU 9912, a RAM 9914, a graphics controller 9916, and a display device 9918, which are mutually connected by a host controller 9910. The computer 9900 further includes input/output units such as a communication interface 9922, a hard disk drive 9924, a DVD drive 9926, and an IC card drive, which are connected to the host controller 9910 via an input/output controller 9920. The computer also includes legacy input/output units such as a ROM 9930 and a keyboard 9942, which are connected to the input/output controller 9920 via an input/output chip 9940.

The CPU 9912 operates according to programs stored in the ROM 9930 and the RAM 9914, thereby controlling each unit. The graphics controller 9916 acquires image data generated by the CPU 9912 on a frame buffer or the like provided in the RAM 9914 or in itself, and causes the image data to be displayed on the display device 9918.

The communication interface 9922 communicates with other electronic devices via a network. The hard disk drive 9924 stores programs and data that are used by the CPU 9912 within the computer 9900. The DVD drive 9926 reads the programs or the data from a DVD-ROM 9901, and provides the hard disk drive 9924 with the programs or the data via the RAM 9914. The IC card drive reads the programs and the data from the IC card, and/or writes the programs and the data to the IC card.

The ROM 9930 stores therein a boot program or the like executed by the computer 9900 at the time of activation, and/or a program depending on the hardware of the computer 9900. The input/output chip 9940 may also connect various input/output units via a parallel port, a serial port, a keyboard port, a mouse port or the like to the input/output controller 9920.

A program is provided by a computer-readable medium such as the DVD-ROM 9901 or the IC card. The program is read from the computer-readable medium, installed into the hard disk drive 9924, the RAM 9914, or the ROM 9930, which are also examples of a computer-readable medium, and executed by CPU 9912. The information processing written in these programs is read into the computer 9900, resulting in cooperation between a program and the above-mentioned various types of hardware resources. An apparatus or method may be constituted by realizing the operation or processing of information in accordance with the usage of the computer 9900.

For example, when a communication is performed between the computer 9900 and an external device, the CPU 9912 may execute a communication program loaded onto the RAM 9914 to instruct the communication interface 9922 to process the communication, based on the processing written in the communication program. The communication interface 9922, under control of the CPU 9912, reads transmission data stored on a transmission buffer region provided in a recording medium such as the RAM 9914, the hard disk drive 9924, DVD-ROM 9901, or the IC card, and transmits the read transmission data to a network or writes reception data received from a network to a reception buffer region or the like provided on the recording medium.

Also, the CPU 9912 may cause all or a necessary portion of a file or a database to be read into the RAM 9914, wherein the file or the database has been stored in an external recording medium such as the hard disk drive 9924, the DVD drive 9926 (the DVD-ROM 9901), the IC card, etc., and perform various types of processing on the data on the RAM 9914. The CPU 9912 then writes back the processed data to the external recording medium.

Various types of information such as various types of programs, data, tables, and databases may be stored in a recording medium and subjected to information processing. The CPU 9912 may perform various types of processing on the data read from the RAM 9914, which includes various types of operations, information processing, condition judging, conditional branch, unconditional branch, search/replacement of information, etc., as described throughout the present disclosure and designated by an instruction sequence of programs, and writes the result back to the RAM 9914. Also, the CPU 9912 may search for information in a file, a database, etc., in the recording medium. For example, when a plurality of entries, each having an attribute value of a first attribute associated with an attribute value of a second attribute, are stored in the recording medium, the CPU 9912 may search for an entry matching the condition whose attribute value of the first attribute is designated, from among the plurality of entries, and read the attribute value of the second attribute stored in the entry, thereby acquiring the attribute value of the second attribute associated with the first attribute satisfying the predetermined condition.

The above-described program or software modules may be stored in the computer-readable medium on the computer 9900 or near the computer 9900. Also, a recording medium such as a hard disk or a RAM provided in a server system connected to a dedicated communication network or the Internet can be used as the computer-readable medium, thereby providing the program to the computer 9900 via the network.

While the present invention has been described above by using the embodiments, the technical scope of the present invention is not limited to the scope of the above-described embodiments. It is apparent to persons skilled in the art that various alterations or improvements can be made to the above-described embodiments. It is also apparent from the described scope of the claims that the embodiments added with such alterations or improvements can be included the technical scope of the present invention.

The operations, procedures, steps, stages, or the like of each process performed by a device, system, program, and method shown in the claims, embodiments, or diagrams can be performed in any order as long as the order is not indicated by "prior to," "before," or the like and as long as the output from a previous process is not used in a later process. Even if the process flow is described using phrases such as "first" or "next" in the claims, embodiments, or diagrams, it does not necessarily mean that the process must be performed in this order.

EXPLANATION OF REFERENCES

100: developing device
200: predicting device
210: processing condition acquisition unit
220: developing solution data acquisition unit
230: prediction unit
240: model storage unit
250: output unit
710: used developing solution data acquisition unit
720: learning unit
810: recommended condition generation unit
9900: computer
9901 DVD-ROM
9910: host controller
9912: CPU
9914: RAM
9916: graphics controller
9918: display device
9920: input/output controller
9922: communication interface
9924: hard disk drive
9926: DVD drive
9930: ROM
9940: input/output chip
9942: keyboard

## Claims

**1.** A predicting device comprising:

a processing condition acquisition unit which acquires a development processing condition in developing;
a developing solution data acquisition unit which acquires developing solution data indicating a composition of a developing solution;
a prediction unit which generates prediction data in which a composition of a developing solution after development is predicted, based on the development processing condition and the developing solution data; and
an output unit which outputs information corresponding to the prediction data.

**2.** The predicting device according to claim 1, wherein the prediction unit uses the prediction data as new developing solution data, repeatedly executes generation processing of the prediction data multiple times, and generates a prediction data group including pieces of the prediction data obtained multiple times.

**3.** The predicting device according to claim 2, wherein the output unit outputs at least a part of the prediction data group.

**4.** The predicting device according to claim 2, further comprising:

a recommended condition generation unit which generates a recommended condition for performing maintenance on the developing solution after the development, based on the prediction data group, wherein
the output unit outputs the recommended condition.

5. The predicting device according to claim 4, wherein for each time the prediction data is generated, the recommended condition generation unit generates the recommended condition that is individual for each cycle of development processing, based on the prediction data.

6. The predicting device according to claim 4, wherein for each time the prediction data group is generated, the recommended condition generation unit generates the recommended condition that is consistently common over development processing performed multiple times, based on the prediction data group.

7. The predicting device according to claim 4, further comprising a control unit which controls a control target that performs the maintenance on the developing solution after the development, according to the recommended condition.

8. The predicting device according to claim 1, further comprising:

a diagnosis unit which diagnoses an abnormality in the developing based on the prediction data, wherein
the output unit outputs information corresponding to a result obtained by the diagnosis.

9. The predicting device according to claim 8, wherein the diagnosis unit diagnoses that an abnormality has occurred in the developing solution after the development, when the prediction data is outside a predetermined management range.

10. The predicting device according to claim 9, wherein the output unit outputs a message to an effect that a full amount of the developing solution after the development should be replaced, when it is diagnosed that an abnormality has occurred in the developing solution after the development.

11. The predicting device according to claim 8, wherein the diagnosis unit diagnoses that an abnormality has occurred in a developing device which executes the developing, when a difference between a development performance estimated from the prediction data and an actually measured development performance does not meet a predetermined standard.

12. The predicting device according to claim 9, wherein the diagnosis unit diagnoses that an abnormality has occurred in a developing device which executes the developing, when a difference between a development performance estimated from the prediction data and an actually measured development performance does not meet a predetermined standard.

13. The predicting device according to claim 12, wherein the diagnosis unit estimates a development performance from the prediction data, when the prediction data is within the management range.

14. The predicting device according to claim 11, wherein the output unit outputs a message to an effect that the developing being executed in the developing device should be stopped, when it is diagnosed that an abnormality has occurred in the developing device.

15. The predicting device according to any one of claims 1 to 14, wherein the prediction unit generates the prediction data, by using a prediction model generated by performing machine learning on a relationship between (a) the development processing condition and the developing solution data and (b) used developing solution data indicating the composition of the developing solution after the development.

16. The predicting device according to claim 15, further comprising:

a used developing solution data acquisition unit which acquires the used developing solution data; and
a learning unit which generates the prediction model by performing machine learning on the development processing condition, the developing solution data, and the used developing solution data, as learning data.

17. The predicting device according to any one of claims 1 to 14, wherein

the developing solution is an aqueous developing solution containing at least any of a surfactant or a development accelerator, and the developing solution data acquisition unit acquires, as the developing solution data, at least any of a concentration of a development residue, a concentration of the surfactant, a concentration of the development accelerator, or a pH in the developing solution, and
the prediction unit generates, as the prediction data, at least any of the concentration of the development residue, the concentration of the surfactant, the concentration of the development accelerator, or the pH in the developing solution after the development.

**18.** The predicting device according to any one of claims 1 to 14, wherein the processing condition acquisition unit acquires, as the development processing condition, at least any of a type of a developing device, an amount of the developing solution, a temperature of the developing solution in the developing, a developing time, a contact pressure of a developing brush, a number of rotations of the developing brush, a maintenance condition of the developing solution, a size of a plate that is made, an image rate, or a development depth.

**19.** The predicting device according to any one of claims 1 to 14, wherein the developing solution is a developing solution that is used for developing an original plate made of resin.

**20.** A developing device for an original plate, comprising the predicting device according to any one of claims 1 to 14.

**21.** A predicting method comprising:

acquiring a development processing condition in developing;
acquiring developing solution data indicating a composition of a developing solution;
generating prediction data in which a composition of a developing solution after development is predicted, based on the development processing condition and the developing solution data; and
outputting information corresponding to the prediction data.

**22.** The predicting method according to claim 21, wherein the generating the prediction data includes using the prediction data as new developing solution data, repeatedly executing generation processing of the prediction data multiple times, and generating a prediction data group including pieces of the prediction data obtained multiple times.

**23.** The predicting method according to claim 21 or 22, further comprising diagnosing that an abnormality has occurred in the developing solution after the development, when the prediction data is outside a predetermined management range.

**24.** The predicting method according to claim 23, further comprising diagnosing that an abnormality has occurred in a developing device which executes the developing, when a difference between a development performance estimated from the prediction data and an actually measured development performance does not meet a predetermined standard.

**25.** A predicting program that, when executed by a computer, causes the computer to function as:

a processing condition acquisition unit which acquires a development processing condition in developing;
a developing solution data acquisition unit which acquires developing solution data indicating a composition of a developing solution;
a prediction unit which generates prediction data in which a composition of a developing solution after development is predicted, based on the development processing condition and the developing solution data; and
an output unit which outputs information corresponding to the prediction data.

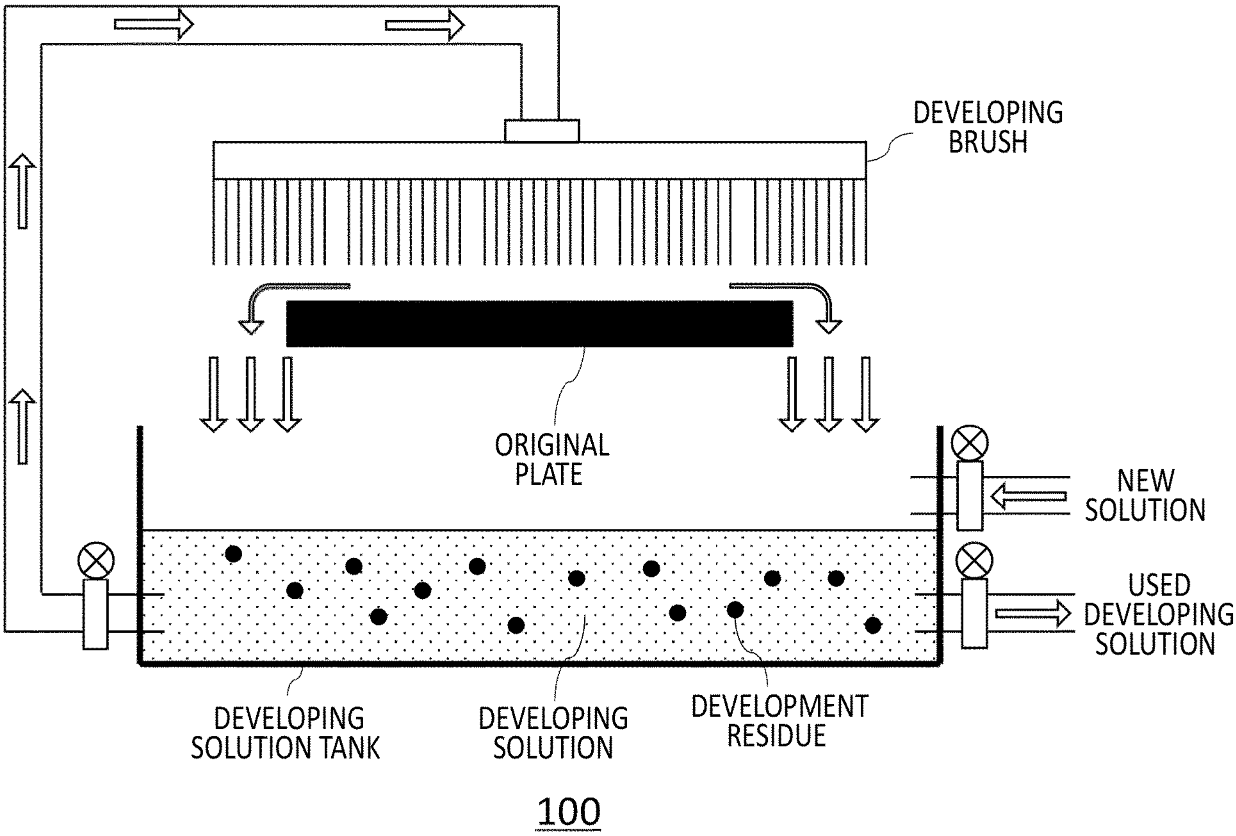
DEVELOPING BRUSH
ORIGINAL PLATE
NEW SOLUTION
USED DEVELOPING SOLUTION
DEVELOPING SOLUTION TANK
DEVELOPING SOLUTION
DEVELOPMENT RESIDUE
100

*FIG.1*

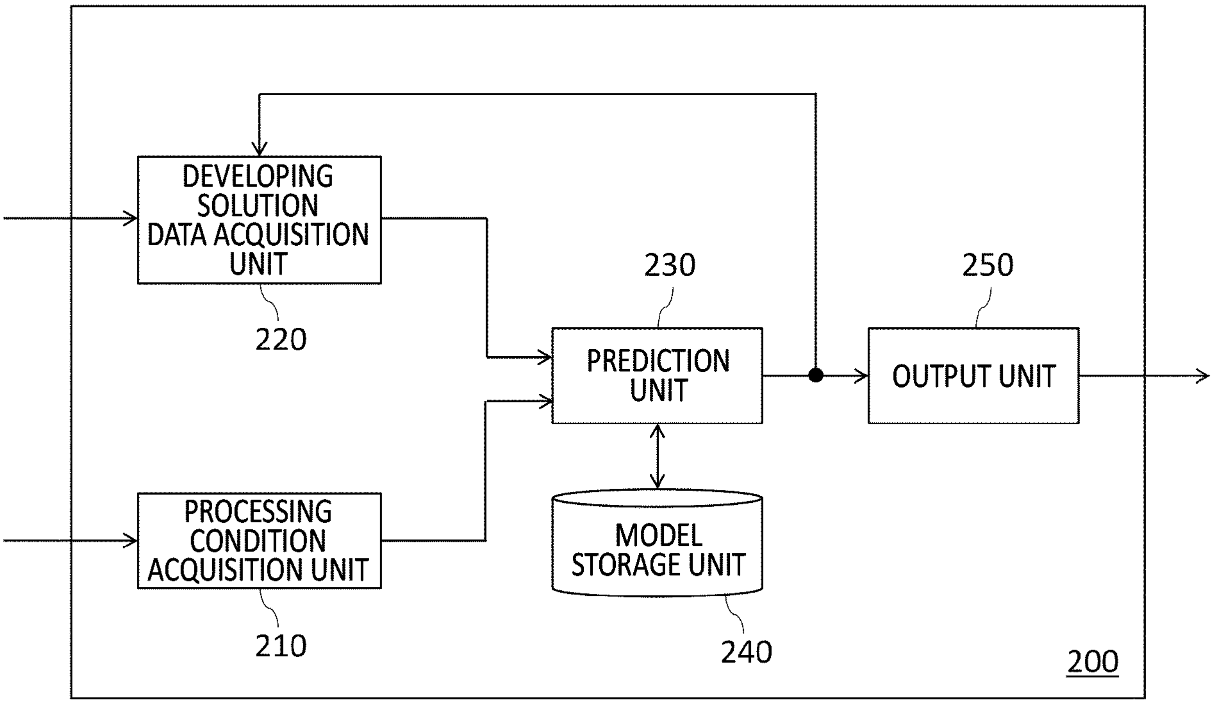
DEVELOPING SOLUTION DATA ACQUISITION UNIT
220
PROCESSING CONDITION ACQUISITION UNIT
210
230
PREDICTION UNIT
MODEL STORAGE UNIT
240
250
OUTPUT UNIT
200

FIG.2

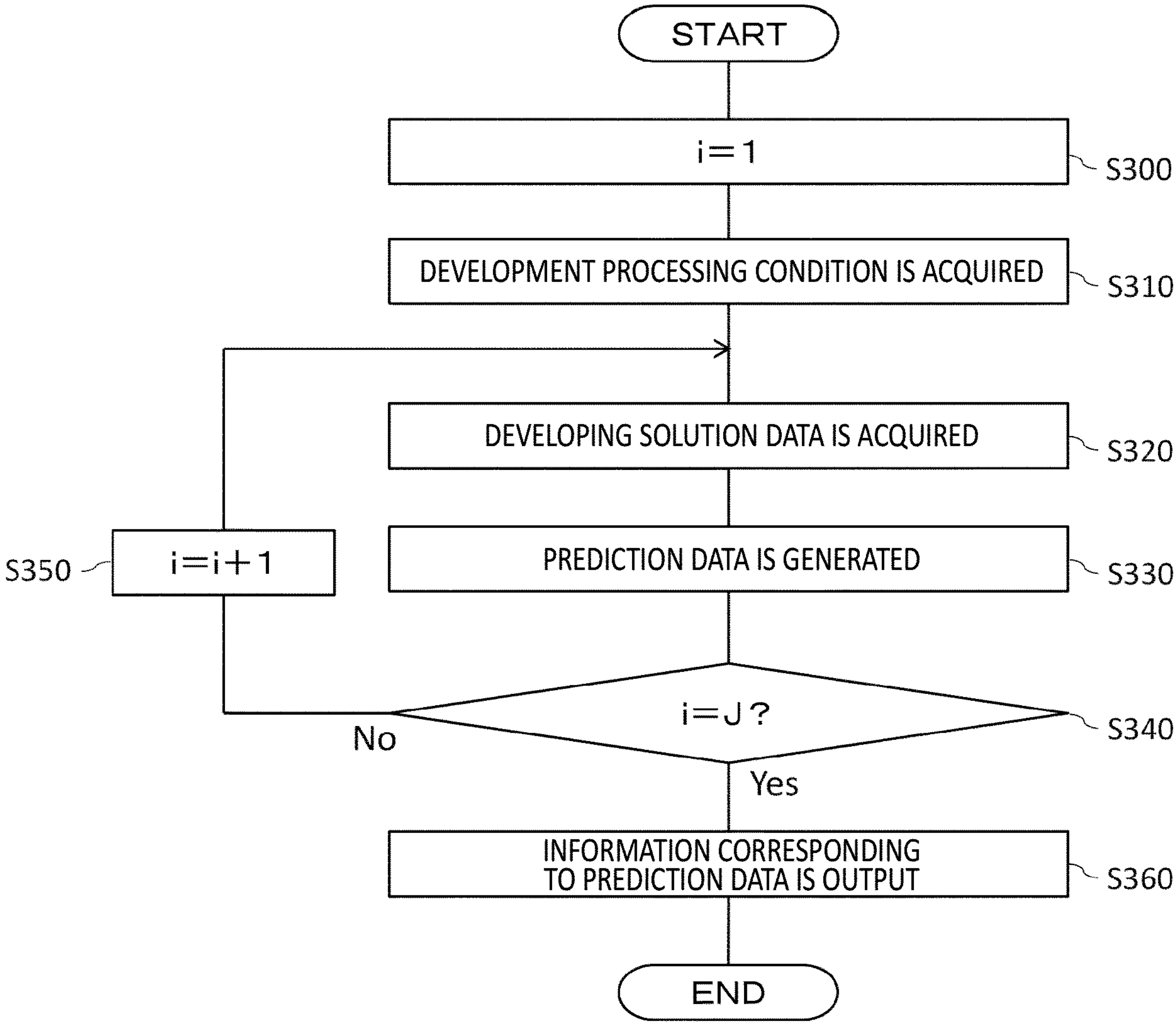
START
i=1
S300
DEVELOPMENT PROCESSING CONDITION IS ACQUIRED
S310
DEVELOPING SOLUTION DATA IS ACQUIRED
S320
PREDICTION DATA IS GENERATED
S330
S350
i=i+1
i=J?
S340
No
Yes
INFORMATION CORRESPONDING TO PREDICTION DATA IS OUTPUT
S360
END

FIG.3

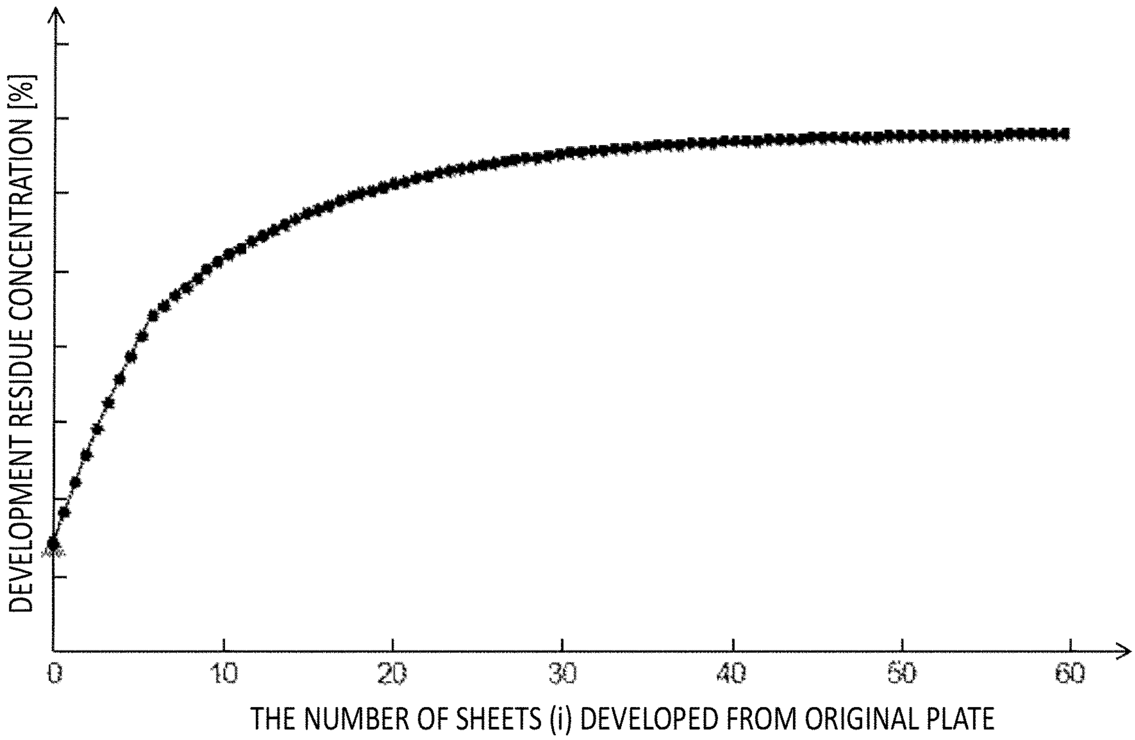
DEVELOPMENT RESIDUE CONCENTRATION [%]
0
10
20
30
40
50
60
THE NUMBER OF SHEETS (i) DEVELOPED FROM ORIGINAL PLATE

*FIG.4*

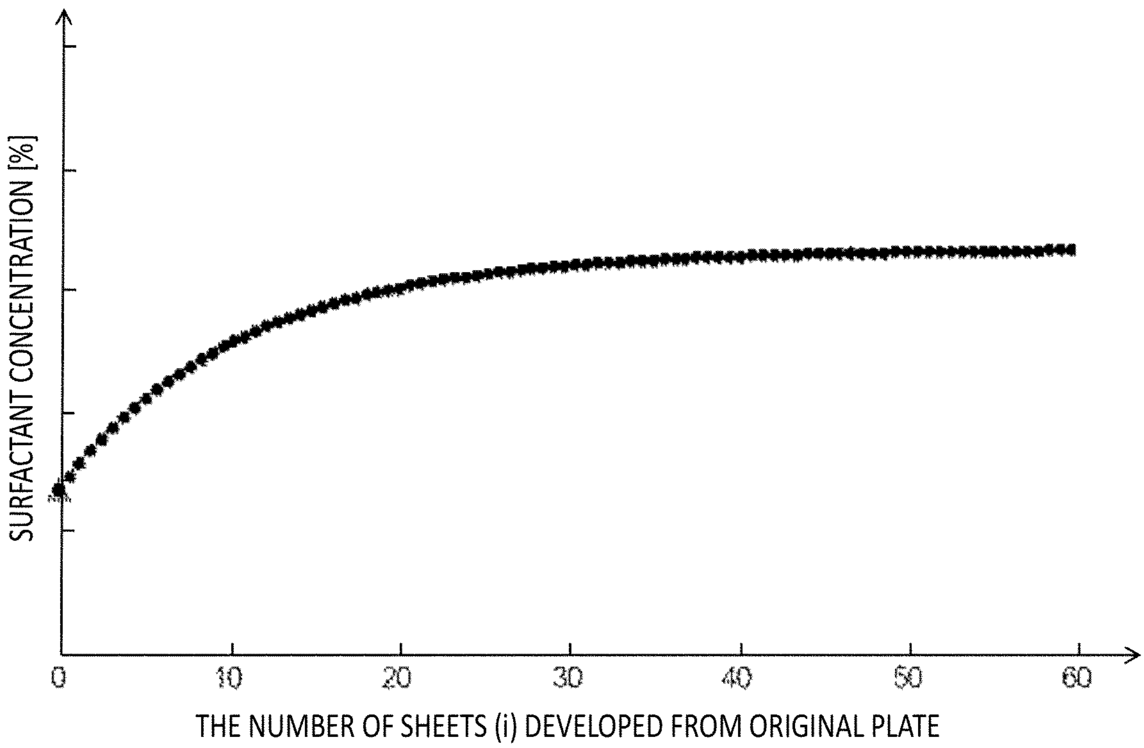
SURFACTANT CONCENTRATION [%]
0
10
20
30
40
50
60
THE NUMBER OF SHEETS (i) DEVELOPED FROM ORIGINAL PLATE

*FIG.5*

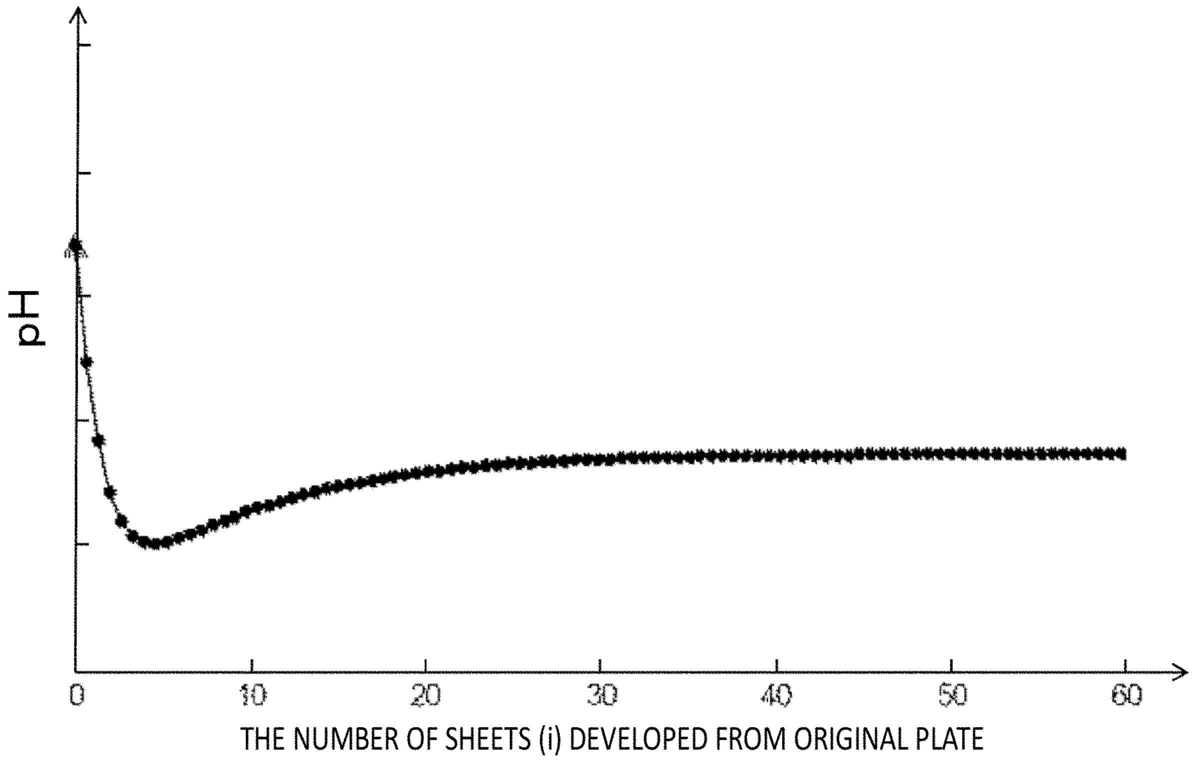
pH
0
10
20
30
40
50
60
THE NUMBER OF SHEETS (i) DEVELOPED FROM ORIGINAL PLATE

*FIG.6*

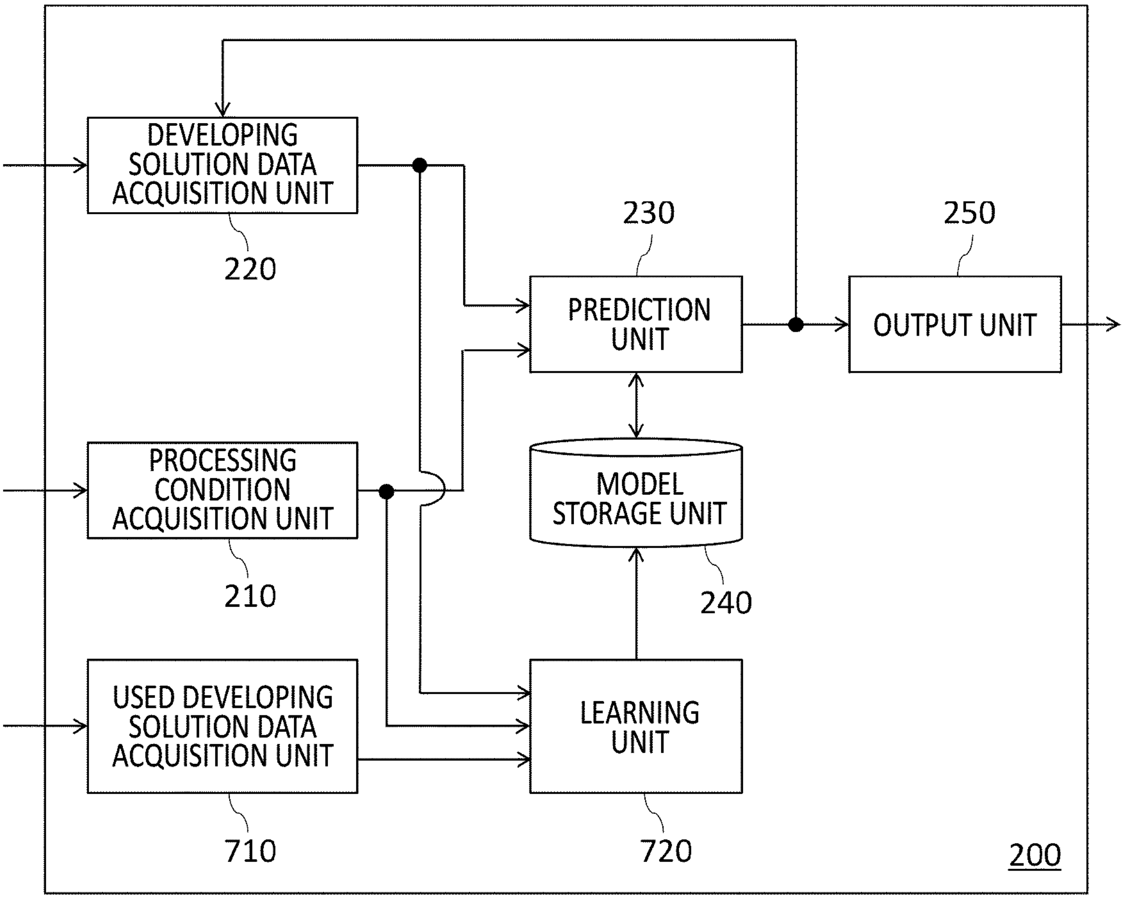
DEVELOPING SOLUTION DATA ACQUISITION UNIT
220
PROCESSING CONDITION ACQUISITION UNIT
210
USED DEVELOPING SOLUTION DATA ACQUISITION UNIT
710
230
PREDICTION UNIT
MODEL STORAGE UNIT
240
LEARNING UNIT
720
250
OUTPUT UNIT
200

*FIG.7*

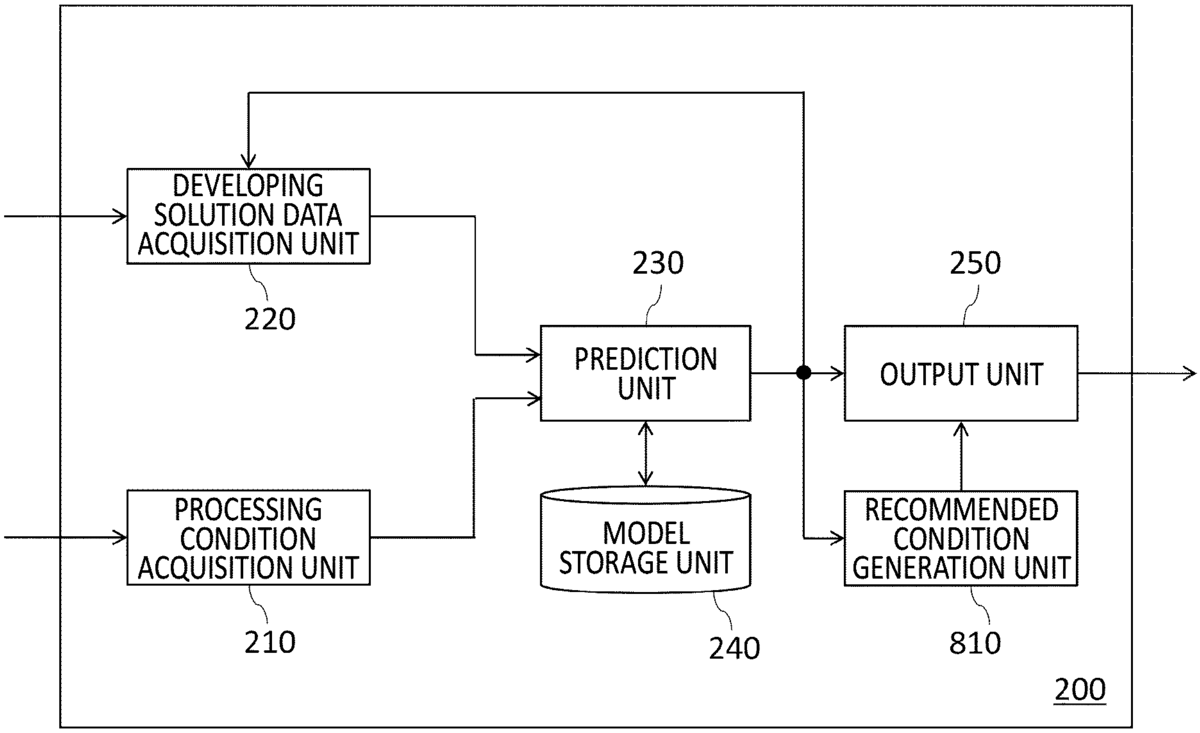
DEVELOPING SOLUTION DATA ACQUISITION UNIT
220
230
PREDICTION UNIT
250
OUTPUT UNIT
PROCESSING CONDITION ACQUISITION UNIT
210
MODEL STORAGE UNIT
240
RECOMMENDED CONDITION GENERATION UNIT
810
200

*FIG.8*

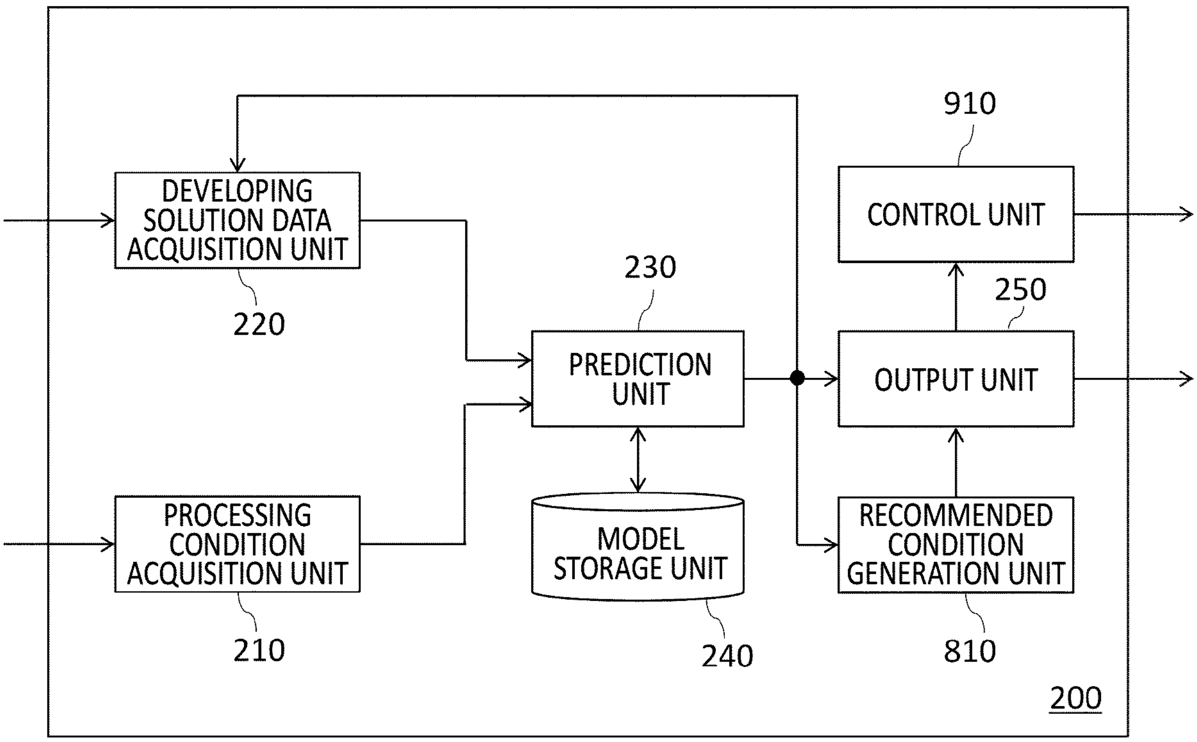
910
DEVELOPING SOLUTION DATA ACQUISITION UNIT
CONTROL UNIT
230
250
220
PREDICTION UNIT
OUTPUT UNIT
PROCESSING CONDITION ACQUISITION UNIT
MODEL STORAGE UNIT
RECOMMENDED CONDITION GENERATION UNIT
210
240
810
200

*FIG.9*

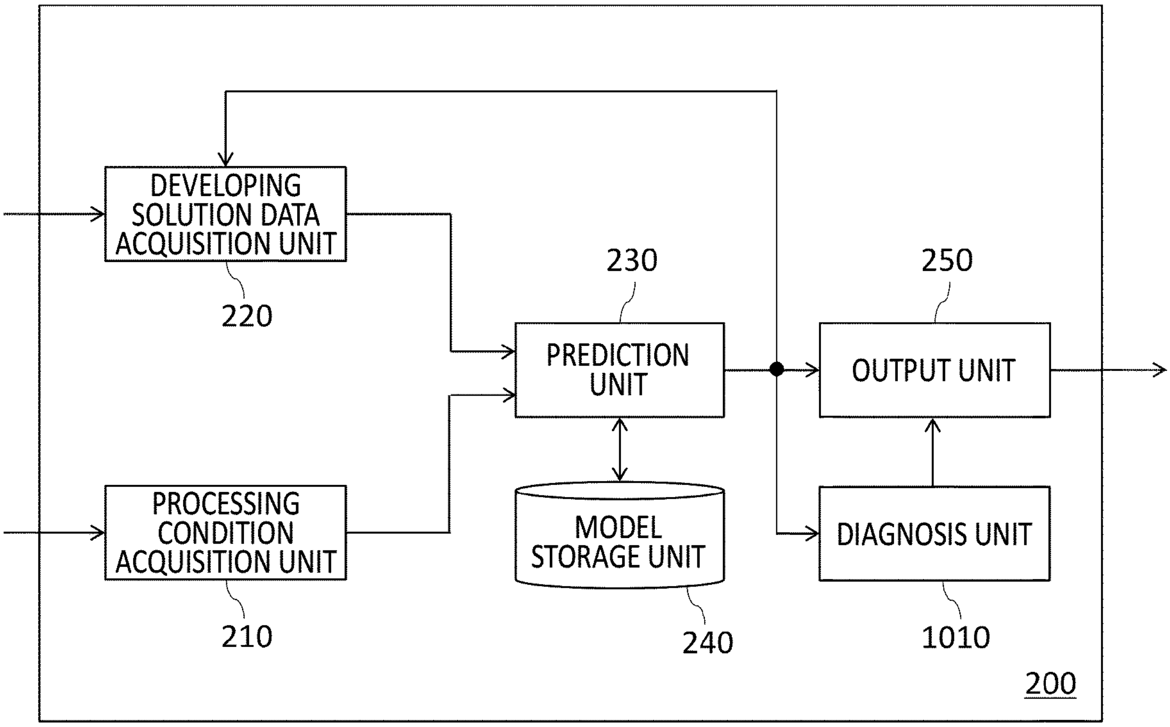
DEVELOPING SOLUTION DATA ACQUISITION UNIT
220
PROCESSING CONDITION ACQUISITION UNIT
210
230
PREDICTION UNIT
MODEL STORAGE UNIT
240
250
OUTPUT UNIT
DIAGNOSIS UNIT
1010
200

*FIG.10*

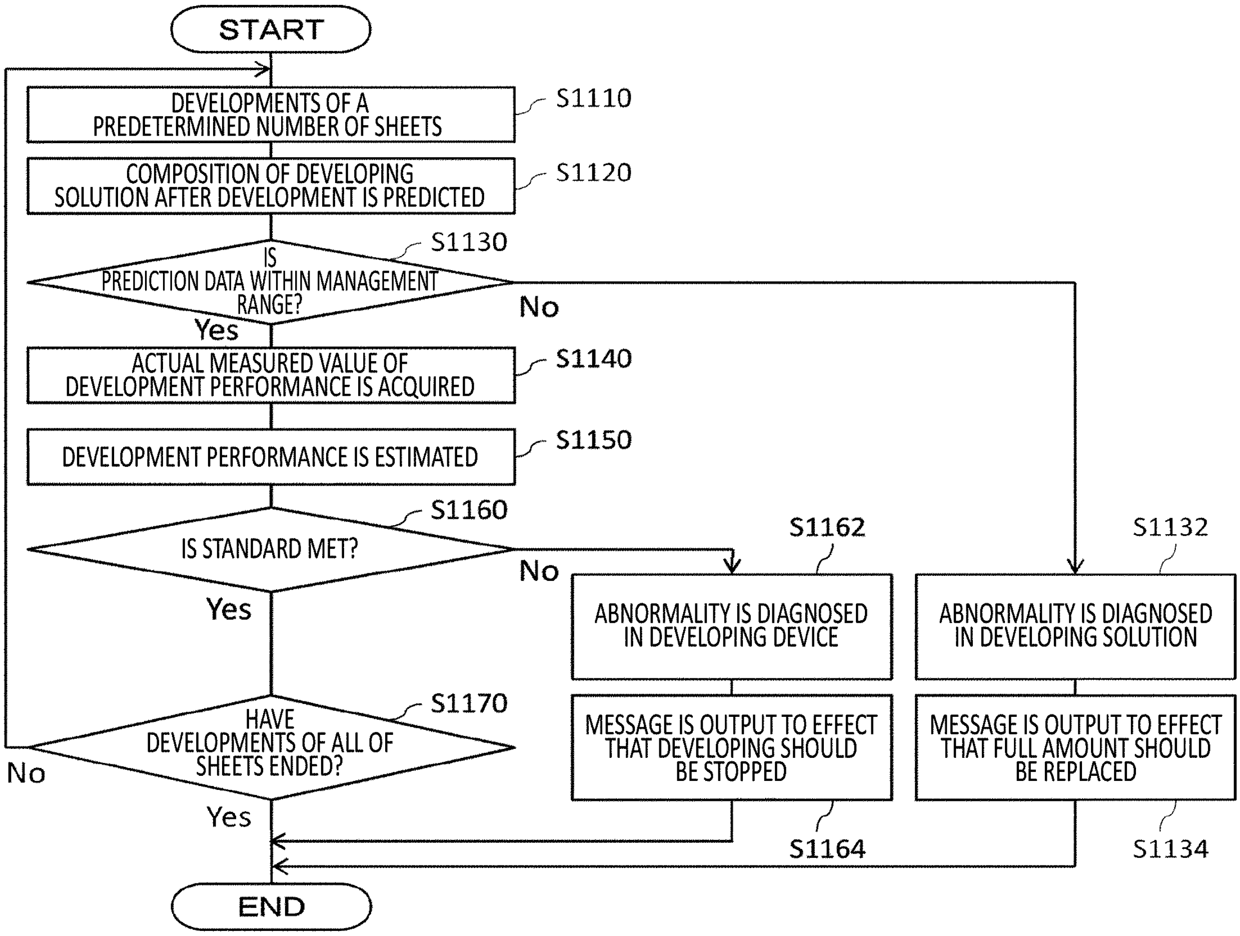
START
DEVELOPMENTS OF A PREDETERMINED NUMBER OF SHEETS
S1110
COMPOSITION OF DEVELOPING SOLUTION AFTER DEVELOPMENT IS PREDICTED
S1120
IS PREDICTION DATA WITHIN MANAGEMENT RANGE?
S1130
No
Yes
ACTUAL MEASURED VALUE OF DEVELOPMENT PERFORMANCE IS ACQUIRED
S1140
DEVELOPMENT PERFORMANCE IS ESTIMATED
S1150
IS STANDARD MET?
S1160
No
Yes
S1162
ABNORMALITY IS DIAGNOSED IN DEVELOPING DEVICE
S1132
ABNORMALITY IS DIAGNOSED IN DEVELOPING SOLUTION
HAVE DEVELOPMENTS OF ALL OF SHEETS ENDED?
S1170
No
Yes
MESSAGE IS OUTPUT TO EFFECT THAT DEVELOPING SHOULD BE STOPPED
S1164
MESSAGE IS OUTPUT TO EFFECT THAT FULL AMOUNT SHOULD BE REPLACED
S1134
END

*FIG.11*

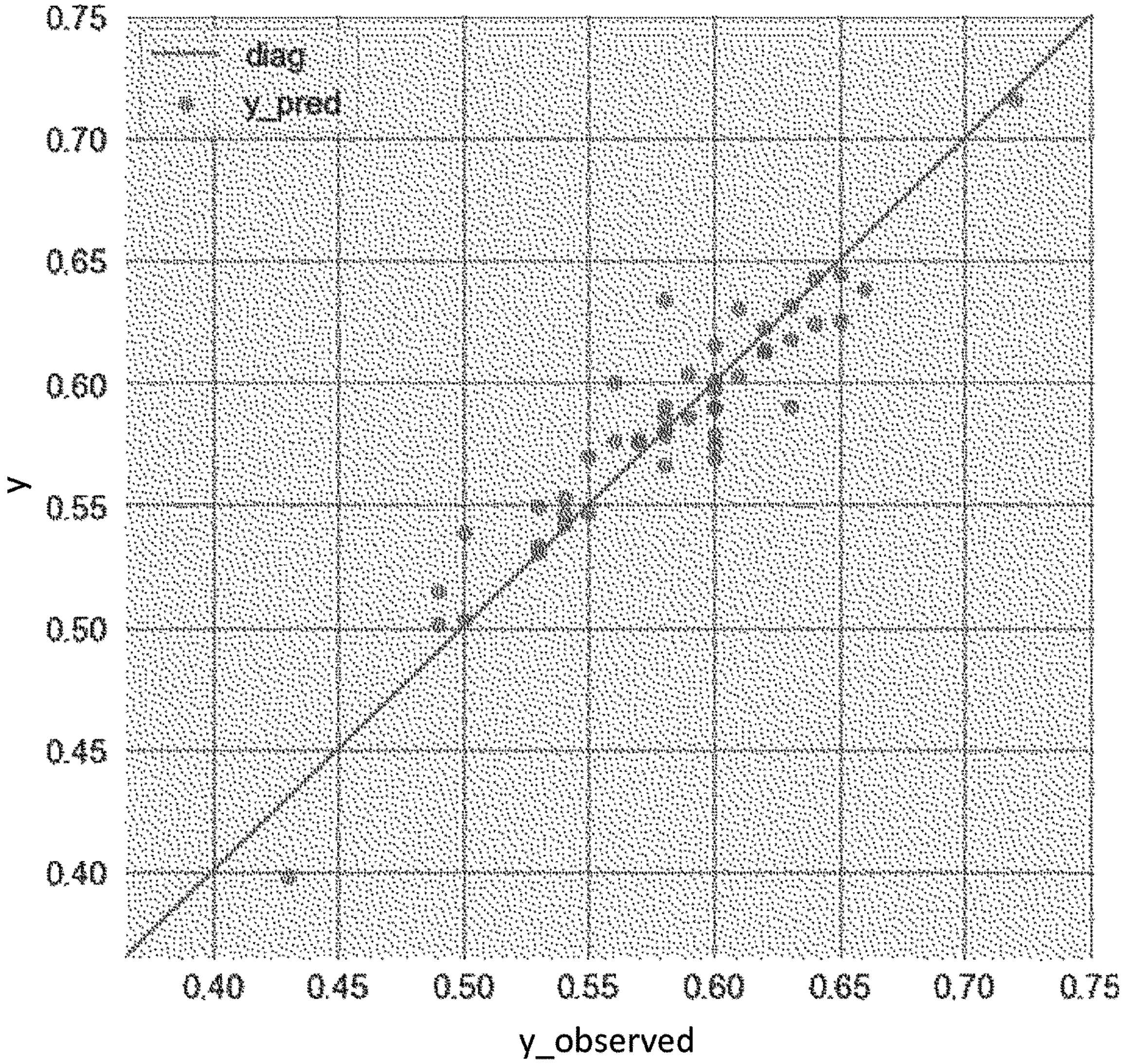
diag
y_pred
0.75
0.70
0.65
0.60
0.55
0.50
0.45
0.40
y
0.40
0.45
0.50
0.55
0.60
0.65
0.70
0.75
y_observed

*FIG.12*

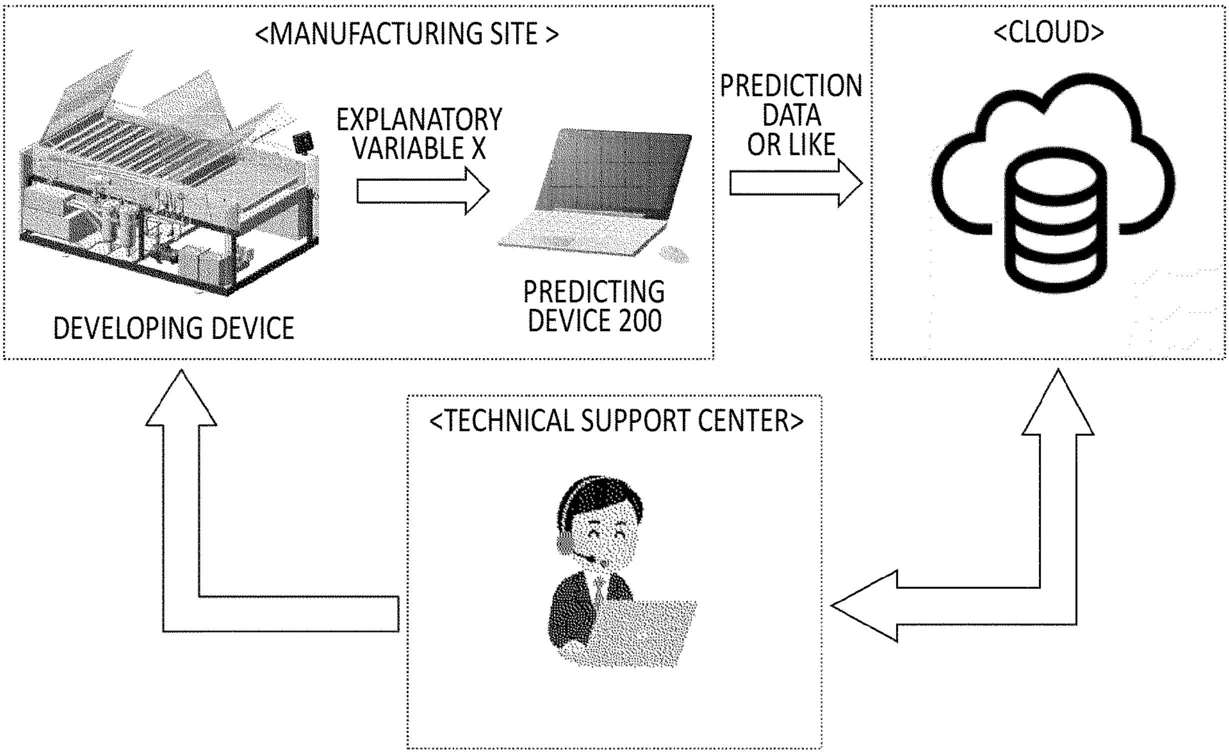
<MANUFACTURING SITE >
EXPLANATORY VARIABLE X
DEVELOPING DEVICE
PREDICTING DEVICE 200
PREDICTION DATA OR LIKE
<CLOUD>
<TECHNICAL SUPPORT CENTER>

FIG.13

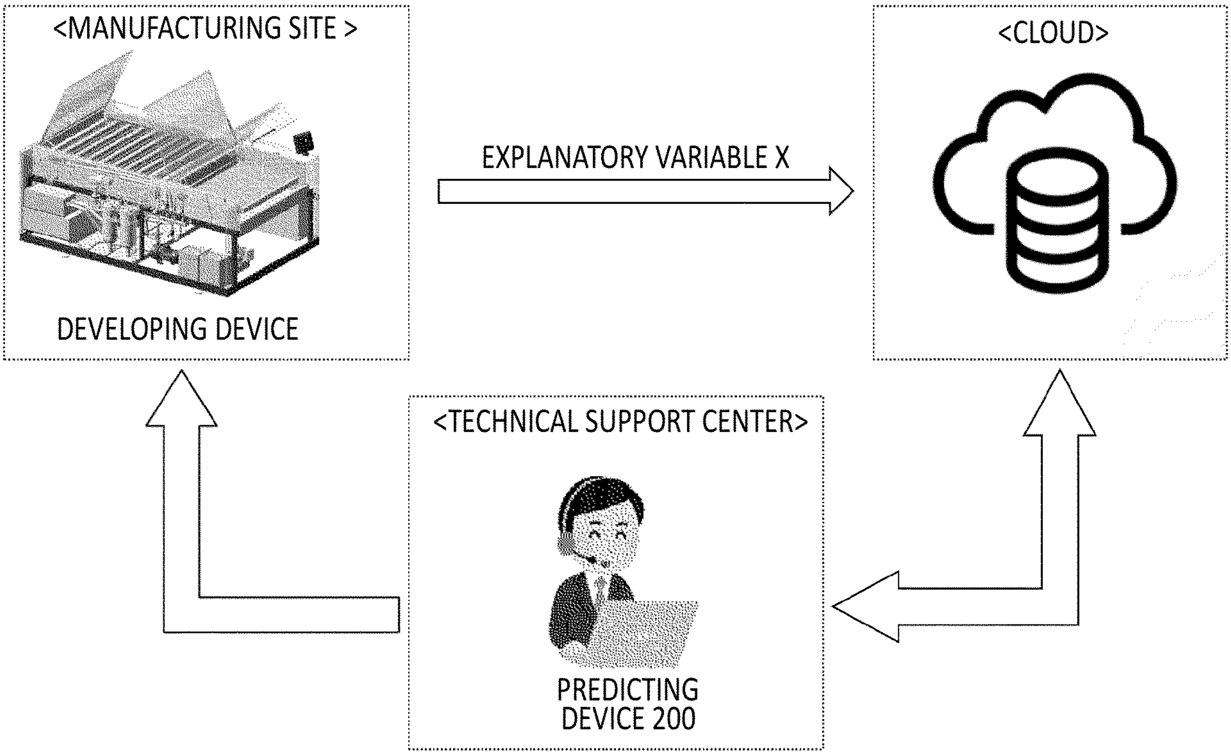
<MANUFACTURING SITE >
DEVELOPING DEVICE
EXPLANATORY VARIABLE X
<CLOUD>
<TECHNICAL SUPPORT CENTER>
PREDICTING
DEVICE 200

FIG.14

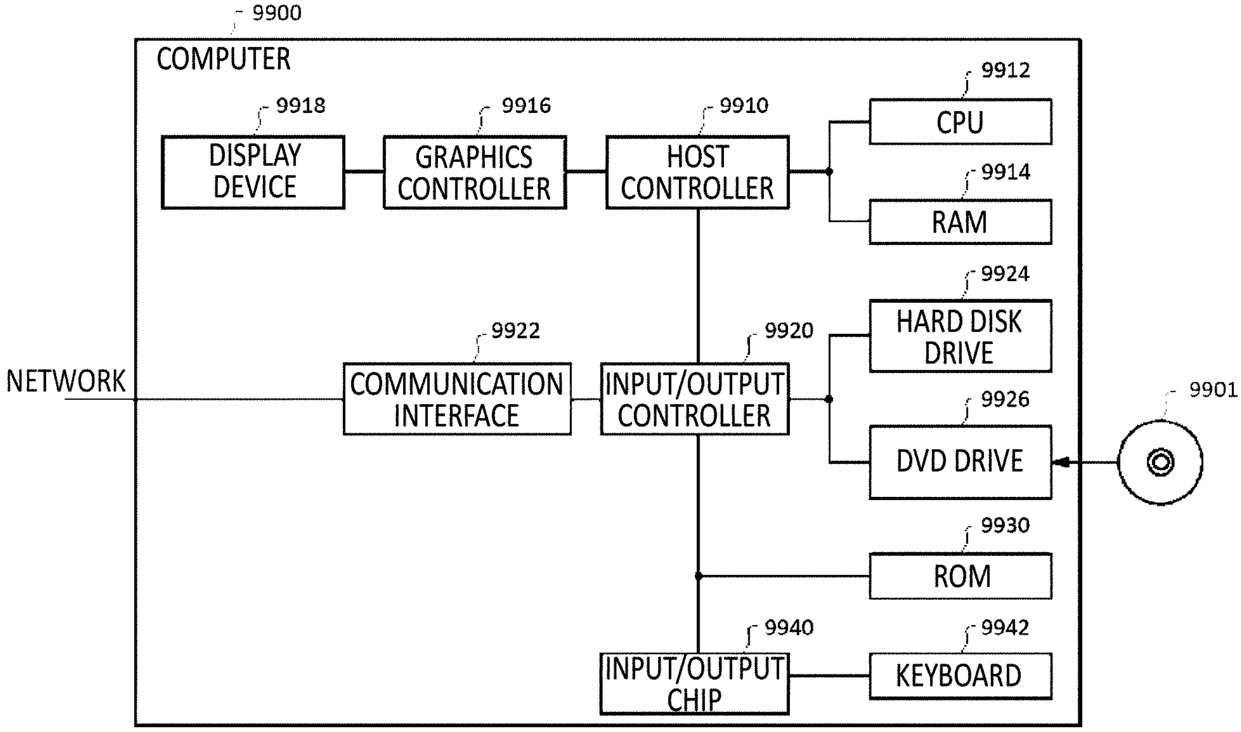
9900
COMPUTER
9918
DISPLAY DEVICE
9916
GRAPHICS CONTROLLER
9910
HOST CONTROLLER
9912
CPU
9914
RAM
9924
HARD DISK DRIVE
9922
9920
NETWORK
COMMUNICATION INTERFACE
INPUT/OUTPUT CONTROLLER
9926
9901
DVD DRIVE
9930
ROM
9940
9942
INPUT/OUTPUT CHIP
KEYBOARD

*FIG.15*

## INTERNATIONAL SEARCH REPORT

International application No.
**PCT/JP2022/031092**

**A. CLASSIFICATION OF SUBJECT MATTER**

***G03F 7/30***(2006.01)i
FI: G03F7/30 501

According to International Patent Classification (IPC) or to both national classification and IPC

**B. FIELDS SEARCHED**

Minimum documentation searched (classification system followed by classification symbols)

G03F7/30

Documentation searched other than minimum documentation to the extent that such documents are included in the fields searched

Published examined utility model applications of Japan 1922-1996
Published unexamined utility model applications of Japan 1971-2022
Registered utility model specifications of Japan 1996-2022
Published registered utility model applications of Japan 1994-2022

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| X<br>A | JP 2002-351090 A (MITSUBISHI CHEMICALS CORP) 04 December 2002 (2002-12-04) claims, paragraphs [0051]-[0056], examples | 1, 17-21, 25<br>2-16, 22-24 |
| A | JP 2003-316022 A (FUJI PHOTO FILM CO LTD) 06 November 2003 (2003-11-06) claims | 1-25 |
| A | JP 2005-92011 A (FUJI PHOTO FILM CO LTD) 07 April 2005 (2005-04-07) claims | 1-25 |
| A | JP 2018-120893 A (HIRAMA LABORATORIES CO., LTD.) 02 August 2018 (2018-08-02) claims | 1-25 |

☐ Further documents are listed in the continuation of Box C. ☑ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| **31 October 2022** | **08 November 2022** |
| Name and mailing address of the ISA/JP<br>**Japan Patent Office (ISA/JP)**<br>**3-4-3 Kasumigaseki, Chiyoda-ku, Tokyo 100-8915**<br>**Japan** | Authorized officer<br><br>Telephone No. |

Form PCT/ISA/210 (second sheet) (January 2015)

**INTERNATIONAL SEARCH REPORT**
**Information on patent family members**

International application No.
**PCT/JP2022/031092**

| Patent document cited in search report | Publication date (day/month/year) | Patent family member(s) | Publication date (day/month/year) |
|---|---|---|---|
| JP 2002-351090 A | 04 December 2002 | (Family: none) | |
| JP 2003-316022 A | 06 November 2003 | (Family: none) | |
| JP 2005-92011 A | 07 April 2005 | (Family: none) | |
| JP 2018-120893 A | 02 August 2018 | (Family: none) | |

Form PCT/ISA/210 (patent family annex) (January 2015)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- JP 2011064796 A